# EUROPÄISCHE PATENTSCHRIFT

(11) **EP 2 539 927 B1**
(45) Veröffentlichungstag und Bekanntmachung des Hinweises auf die Patenterteilung: **04.12.2019**
(21) Anmeldenummer: 11709029.0
(22) Anmeldetag: 22.02.2011
(51) Int. Cl.: H01L 21/67, H01L 21/673, C23C 16/458, H01L 31/032, H01L 31/18

(54) **ANORDNUNG, ANLAGE UND VERFAHREN ZUR PROZESSIERUNG VON MEHRSCHICHTKÖRPERN**
Device for positioning at least two objects, assemblies in particular multi-layer body assemblies, assembly for processing, in particular selenization, of objects, method for positioning at least two objects
Dispositif de positionnement d'au moins deux objets, agencements, notamment agencements de corps multicouches, installation de traitement, notamment pour la sélénisation d'objets, procédé de positionnement d'au moins deux objets

(30) Priorität: 23.02.2010 EP 10154370
(43) Veröffentlichungstag der Anmeldung: 02.01.2013
(73) Patentinhaber: (CNBM) Bengbu Design & Research Institute for Glass Industry Co., Ltd., Bengbu (CN)
(72) Erfinder: JOST, Stefan, 81543 München (DE); PALM, Jörg, 80797 München (DE); FÜRFANGER, Martin, 85643 Steinhöring (DE)
(74) Vertreter: Gebauer, Dieter Edmund
(86) Internationale Anmeldenummer: PCT/EP2011/052581
(87) Internationale Veröffentlichungsnummer: WO 2011/104222

(56) Entgegenhaltungen:
- EP-A1- 1 833 097
- WO-A1-2004/025716
- WO-A2-2004/032593
- GB-A- 2 331 509
- JP-A- 60 021 897
- JP-A- 2008 124 091
- US-A- 4 593 644
- US-A1- 2002 076 882
- US-A1- 2006 105 498

## Beschreibung

Die Erfindung betrifft eine Anordnung, eine Anlage und ein Verfahren zum Prozessieren, insbesondere Selenisieren, von Mehrschichtkörpern.

Nachfolgend wird das Prozessieren von Mehrschichtkörpern beschrieben, z. B. von Substraten (z. B. Glassubstrate). Auch wenn der spezielle Begriff des "Substrates" verwendet wird, so beziehen sich die Ausführungen auch immer allgemein auf "Mehrschichtkörper". Als Substrat kann ein "nacktes", unbeschichtetes Substrat bezeichnet werden, ebenso wie ein beschichtetes, also auch ein Mehrschichtkörper. Ein Mehrschichtkörper wird beispielsweise durch Aufbringen einer funktionellen Schicht auf eine Trägerschicht ausgebildet. Damit die Schichten oder zumindest die funktionelle Schicht gewünschte physikalische und/oder chemische Eigenschaften aufweisen, muss der Mehrschichtkörper bzw. müssen die Schichten ggf. einer Prozessierung unterzogen werden. Das Prozessieren kann beispielsweise als ein Temperieren bzw. Tempern in Gegenwart eines Prozessgases vorgesehen sein. Hierfür sind Anlagen vorgesehen, in der ein Mehrschichtkörper aufheizbar ist.

Eine solche Anlage ist etwa in der JP 2008 124091 A beschrieben.

Die Mehrschichtkörper werden eingesetzt, um beispielsweise (insbesondere großflächige) Dünnschichthalbleiter herzustellen, beispielsweise Dünnschichtsolarzellen bzw. -module. Solarstromanlagen werden z. B. mit Solarmodulen auf der Basis von Chalkopyrit-Halbleitern (z. B. CuInSe₂, abgekürzt "CIS" oder Cu(In,Ga)(S,Se)₂, abgekürzt "CIGSSE") betrieben. Solche Dünnschichtsolarmodule weisen zumindest ein Substrat (z. B. Glas, Keramik, Metall- oder Kunststofffolie), eine erste Elektrode (z. B. Molybdän Mo oder ein Metallnitrid), eine Absorberschicht (z. B. CuInSe₂ oder allgemeiner (Ag,Cu)(In,Ga,Al)(Se,S)₂), eine Frontelektrode (z.B. ZnO oder SnO₂) und Verkapselungs- und Abdeckmaterialien (z. B. EVA/Glas oder PVB/Glas, wobei EVA für Ethylen-Vinylacetat und PVB für Polyvinylbutyral steht) als wesentliche Bestandteile auf. Weitere Schichten, wie z. B. Alkalibarrierenschichten zwischen Glas und Mo oder Pufferschichten zwischen Absorber und Fensterschicht können eingesetzt werden, um den Wirkungsgrad und/oder die Langzeitstabilität zu verbessern. Wesentlicher weiterer Bestandteil eines typischen Dünnschichtsolarmoduls ist die integrierte Serienverschaltung, die aus Einzelsolarzellen eine serienverschaltete Kette bildet und damit höhere Betriebsspannungen ermöglicht. Im Folgenden werden jeweils die chemischen Zeichen für bestimmte Elemente angegeben, beispielsweise "Mo" für Molybdän oder "Se" für Selen. Labortechnische Versuche zeigen, dass die derzeit bekannten Herstellverfahren noch weit mehr verbessert und dass durch verfahrenstechnische Ansätze und Optimierungen wesentliche Kosteneinsparungen erreicht werden können. Derzeit gibt es verschiedene Verfahren zur Herstellung der Dünnschicht-Solarmodule auf der Basis von Chalkopyrit-Halbleitern. Bei einem bekannten Zweistufen-Verfahren werden in einem ersten Schritt die sogenannten Precursorschichten Cu(Ga), In und Se auf das kalte, bereits mit einer Mo-Dünnschicht versehene Substrat abgeschieden. Dies kann z. B. durch Sputtern, Elektrodeposition, Siebdruck, Verdampfungsprozesse oder chemische Gasphasenabscheidung erfolgen. In einem zweiten Schritt wird das dergestalt beschichtete Substrat in einer Prozesskammer (eines entsprechenden Ofens) unter Ausschluss von Luft erhitzt, indem ein vorgegebenes erprobtes TemperaturProfil von Raumtemperatur bis ca. 600°C durchfahren wird. Während dieses Temperprozesses bildet sich aus den Precursorschichten in einer komplexen Phasenumwandlung der gewünschte Chalkopyrit-Halbleiter. Dieser Prozess kann als In-Line-Prozessierung bezeichnet werden, z. B. In-Line-Selenisierung. Auch die Sulfurierung ist auf diesem Wege möglich. In-Line-Temperprozesse erfordern die sichere Beherrschung schneller CIS-Schichtbildungsprozesse, sowie der ebenfalls beschleunigten Aufheiz- und Abkühlprozesse für z. B. große beschichtete Glasplatten. Dabei wird ein Schichtpaket bestehend aus z. B. Kupfer, Indium und Gallium, sowie einer abschließenden Bedeckung aus elementarem Selen mit relativ hohen Aufheizraten von bis zu einigen K/s auf höhere Temperaturen gebracht, bei der die zuvor aufgetragenen Einzelkomponenten zur Halbleiterverbindung reagieren (schnelle thermische Prozessierung, Rapid Thermal Processing, RTP, von Schichtstapel-Vorläuferschichten, SEL-Precursor, Stacked Elemental Layer). Die gegenüber Ofenprozessen wesentlich kürzeren Reaktionszeiten erlauben nun eine Übertragung auf Durchlaufprozesse. Die Prozesskammer weist z. B. einen Tunnel auf bzw. bildet einen Tunnel aus, der beispielsweise mit Schleusen abdichtbar ist oder ist als eine abgeschlossene Prozesskammer vorgesehen. Die Prozesskammer wird mit Energiequellen, also z. B. matrixförmig angeordneten Strahlern zum Aufheizen bestrahlt. Die großflächige Prozessierung von Cu(In,Ga)(S,Se)₂ (CIGSSE) Chalkopyrit-Halbleitern auf Glassubstraten, ausgehend von SEL-Precursorn erfordert also folgende grundsätzliche Voraussetzungen: schnelle Aufheizraten im Bereich einiger K/s, homogene Temperaturverteilung über das

Glassubstrat (lateral) und über die Substrat-Dicke, Gewährleistung eines ausreichend hohen, kontrollierbaren und reproduzierbaren Partialdrucks der Chalkogenelemente (Se und/oder S) während des RTPs (Vermeidung von Se- und/oder S-Verlusten bzw. sonstigen aufgebrachten Elementen), kontrollierte Prozessgas-Zufuhr (z. B. H₂, N₂, Ar, H₂S, H₂Se, S-Gas, Se-Gas), und Maximal-Temperaturen oberhalb von 500°C. Die großtechnischen In-Line-Verfahren sind prozess- und anlagentechnisch sehr komplex. Dies führt dazu, dass die Investitionskosten für diesen Prozessschritt einen nicht unwesentlichen Anteil an den gesamten Investitionskosten einer Solarfabrik einnehmen.

Aufgabe der Erfindung ist es daher, die thermische Prozessierung von Mehrschichtkörpern effizienter zu gestalten und so die Investitionskosten, insbesondere für entsprechende Prozessieranlagen, und damit auch die Produktionskosten zu senken. Diese Aufgabe wird durch eine Anordnung von Mehrschichtkörpern, sowie eine Anlage und ein Verfahren zum Prozessieren von Mehrschichtkörpern mit den Merkmalen der nebengeordneten Ansprüche gelöst. Vorteilhafte Ausgestaltungen der Erfindung sind durch die Merkmale der Unteransprüche gegeben.

Insbesondere wird die Aufgabe durch eine Anordnung von Mehrschichtkörpern, im Weiteren auch als "Mehrschichtkörperanordnung" bezeichnet, gelöst. Die Mehrschichtkörperanordnung umfasst mindestens zwei Mehrschichtkörper mit jeweils mindestens einer zu prozessierenden Oberfläche, sowie mindestens eine Vorrichtung zum Positionieren der mindestens zwei Mehrschichtkörper, wobei die Vorrichtung derart ausgebildet ist, dass sich die jeweils zu prozessierenden Oberflächen gegenüberliegen und so einen zwischen den Oberflächen angeordneten, quasi-geschlossenen Prozessraum ausbilden, in dem im Wesentlichen die Prozessierung erfolgt. Damit sind die Mehrschichtkörper als eine Mehrschichtkörperanordnung in einer Prozessieranlage prozessierbar, insbesondere selenisierbar. Hierbei können die Mehrschichtkörper einen gewissen Abstand zueinander aufweisen, wobei die zu prozessierenden Oberflächen aber auch unmittelbar aufeinander liegen können. Auch dann kann noch von einem Prozessraum gesprochen werden. Somit bilden die insbesondere mit einem gewissen Abstand zueinander angeordneten Mehrschichtkörper einen im Wesentlichen geschlossenen bzw. quasi-geschlossenen Prozessraum aus. Im Sinne vorliegender Erfindung beschreibt der Ausdruck "quasi-geschlossen" einen Prozessraum, der am Rand offen ist, wobei aber zumindest für den Zeitraum der Prozessierung der Mehrschichtkörper praktisch kein Gasaustausch zwischen dem Prozessraum und seiner Umgebung stattfindet, so dass keine nennenswerte Veränderung der Prozessbedingungen im Prozessraum stattfindet, da Randeffekte bezüglich eines Gasaustauschs mit der Umgebung zu vernachlässigen sind. Zudem kann eine den Prozessraum gasdicht abdichtende Barriere bzw. ein den Prozessraum gasdicht umgebender Rahmen vorgesehen sein. In der erfindungsgemäßen Mehrschichtkörperanordnung sind die beiden Mehrschichtkörper so voneinander beabstandet, dass sich zwischen dem zur Umgebung hin offenen Prozessraum und der äußeren Umgebung eine Gasaustauschbarriere bzw. ein Druckausgleichswiderstand ausbildet, wodurch verhindert wird, dass verdampfende Schichtkomponenten, Prozessgase bzw. Prozessreaktionsgase in die äußere Umgebung in unkontrollierter Menge übertreten. Erreicht werden kann dies durch eine geeignete Wahl des (von Null verschiedenen) Abstands zwischen den einander gegenüberliegenden, zu prozessierenden Oberflächen der Mehrschichtkörper, welcher vom Volumen des Prozessraums, der mittleren freien Weglänge der Gaspartikel bzw. den jeweiligen Partialdrücken der Gase im Prozessraum abhängt. Beispielsweise beträgt ein von Null verschiedener Abstand zwischen den einander gegenüberliegenden, zu prozessierenden Oberflächen der Mehrschichtkörper weniger als 50 mm, vorzugsweise weniger als 10 mm, besonders bevorzugt 1 bis 8 mm, und kann bei sehr dünnen Mehrschichtkörpern (z.B. Folien) auch weniger als 1 mm betragen. Diese Werte beziehen sich auf Mehrschichtkörper, deren zu prozessierenden Flächen jeweils beispielsweise eine Größe im Bereich von 100 cm² bis 200000 cm² haben. Vorteilhaft ist der (von Null verschiedene) Abstand zwischen den einander gegenüberliegenden, zu prozessierenden Oberflächen der Mehrschichtkörper so gewählt, dass ein Massenverlust von Gasen im Prozessraum, beispielsweise Chalcogenkomponenten (S, Se), die beispielsweise durch einen Aufheizprozess entstehen (Verdampfen und Ausdiffusion) kleiner als 50%, vorzugsweise kleiner als 20%, insbesondere bevorzugt kleiner als 10%, stärker bevorzugt kleiner als 1%, und noch stärker bevorzugt kleiner als 0,1% ist.

Ohne eine Barriere bzw. Rahmen, durch welche der Prozessraum gasdicht umschlossen wird, liegt in der Mehrschichtkörperanordnung zwischen den Rändern der einander gegenüberliegenden, zu prozessierenden Oberflächen der beiden Mehrschichtkörper eine (Gasdurchtritts-)Öffnung des Prozessraums vor. Diese Öffnung verfügt je nach Abstand d der beiden Mehrschichtkörper über eine gewisse Öffnungsfläche S. Bei rechteckigen Substraten mit Kantenlänge a und b, die in einem Abstand d (Abstand zwischen den beiden zu prozessierenden Oberflächen, die sich in der Mehrschichtkörperanordnung gegenüberliegen) positioniert sind, ist die Öffnungsfläche S an den Substraträndern gegeben durch den Zusammenhang S = (2·a + 2·b)·d. Anderseits wird im Prozessraum an den beiden Substraten eine Gesamtprozessierfläche T prozessiert, bestehend aus den beschichteten Oberflächen der beiden Substrate. Die Gesamtprozessierfläche T ist gegeben durch den Zusammenhang T = 2·a·b (zwei rechteckige, beschichtete Substrate der Kantenlänge a und b). Betrachtet man nun das Verhältnis von Öffnungsfläche S zu Gesamtprozessierfläche T (bezeichnet als A = S / T), so ist es in der Mehrschichtkörperanordnung vorteilhaft, wenn A maximal einen Wert von 0,4 hat, vorzugsweise maximal einen Wert von 0,2 hat, insbesondere bevorzugt maximal einen Wert von 0,02 und noch stärker bevorzugt maximal einen Wert vom 0,002 hat.

Die erfindungsgemäße Ausführungsform sieht vor, dass die zwei Mehrschichtkörper und ein erstes Beabstandungselement oder die zwei Mehrschichtkörper und das erste Beabstandungselement und ein zweites Beabstandungselement derart zueinander angeordnet sind, dass sie einen im Wesentlichen geschlossenen, also quasi-geschlossenen Prozessraum ausbilden, im Sinne einer Abgrenzung von reaktiver Dünnschicht und Ofenumgebung bzw. Kammerraum. Das heißt, die Substrate bilden Deckelelement und Bodenelement einer Prozessbox, während das oder die Beabstandungselemente z. B. als Seitenwandelemente der Prozessbox vorgesehen sind. Das Mehrschichtkörper-Sandwich stellt in diesem Fall ein Analogon zu einer expliziten Prozessbox dar. Der Prozessraum ist damit in gewünschter Weise reduziert, lediglich die zu prozessierenden Oberflächen werden dem Prozessgas ausgesetzt. In dieser dargelegten Prozess-Variante wird versucht, durch eine Minimierung der Kammer-Umgebung einen ausreichend hohen (z.B.) Se-Partialdruck auch ohne Einsatz einer expliziten Prozessbox zu gewährleisten.

Ein wesentlicher Punkt der Erfindung liegt darin, zwei Mehrschichtkörper, z. B. Glassubstrate mit Precursor-Beschichtung, gleichzeitig prozessieren zu können (Dual-Substrate Head-to-Head RTP), da sie durch die Vorrichtung zum Positionieren (auch Stützvorrichtung) entsprechend gelagert oder gestützt sind. Beide Substrate sind mit den Precursor-Elementen, z. B. Cu, Ga, In, Se, Na, beschichtet, wobei diese beschichteten, zu prozessierenden Oberflächen gegenüberliegend angeordnet sind. Bei Beibehaltung der Prozesszeit führt dies zu verdoppeltem Anlagen-Durchsatz bei nahezu konstanter Anlagen-Grundfläche und vergleichbarem Anlagen-Investitionsvolumen. Das heißt, das Anlagen-Design kann im Wesentlichen beibehalten werden.

Die zu prozessierenden Mehrschichtkörper weisen, wie bereits oben beschrieben, bereits erste Beschichtungen auf (Precursor). Auf diese Beschichtungen werden weitere Elemente abgeschieden und/oder es finden Umwandlungen in den Beschichtungen statt, um den Precursor zum gewünschten Halbleiter überzuführen. Die sich gegenüberliegenden Oberflächen sind daher im Folgenden ganz allgemein als "Beschichtung", als "beschichtete Oberflächen", als "beschichtete Seite", als "zu prozessierende Oberflächen" etc. bezeichnet.

Die Erfindung ist nicht nur auf Chalkopyrit-Halbleiter bezogen, sondern auch auf sämtliche Anwendungen von funktionalen Dünnschichten auf Substraten (z. B. CdTe-Halbleiter und verwandte Halbleiter neben den Chalkopyrit-Halbleitern.

Vorzugsweise ist die Vorrichtung (und damit schließlich die Mehrschichtkörperanordnung) in einer Prozesskammer oder einem Prozesstunnel der Prozessieranlage mit einem Kammerraum (oder Tunnelraum) und/oder in einer Einrichtung zum Ausbilden eines reduzierten Kammerraums und/oder auf oder an einem Tragelement zum Transportieren der Mehrschichtkörperanordnung mittels einer Transportvorrichtung in die Prozessieranlage (d.h. in die Prozesskammer oder den -tunnel) und aus dieser heraus oder an einer sonstigen geeigneten bzw. dafür vorgesehenen Stelle, anordenbar oder angeordnet ("anordenbar" kann auch als "vorsehbar" verstanden werden). Die Vorrichtung ist also z. B. derart ausgebildet, dass sie außerhalb der Prozessieranlage zur Aufnahme der Mehrschichtkörper angeordnet werden kann, um sie schließlich in die Kammer oder den Tunnel einzufahren. Hierfür ist beispielsweise die Transportvorrichtung vorgesehen, die die Mehrschichtkörperanordnung bewegt und in die Anlage und auch wieder aus dieser heraus transportiert. Die Vorrichtung ist hierfür vorzugsweise derart ausgebildet, dass sie mit der Transportvorrichtung auf dem Tragelement (einem Carrier, eine Art Transporteinrichtung, wie z. B. eine Transportplatte) transportierbar ist. Auch der Carrier allein kann die Transportvorrichtung ausbilden. Die Mehrschichtkörperanordnung kann auch manuell in die Anlage eingebracht oder direkt in dieser zusammengebaut werden. Um möglichst wenig Prozessgas zu verbrauchen, ist es zweckmäßig, den Kammerraum zu reduzieren und einen expliziten Prozessraum zu schaffen. Zwischen den Substraten und den Energiequellen können daher mindestens teiltransparente Scheiben (z.B. aus Glaskeramik) oder für die gewählte Energiequelle hoch absorbierende Scheiben, die als sekundäre Energiequelle bzw. als Energietransmitter fungieren, angeordnet sein, die einen definierten Prozessraum bilden, um im Heizprozess das Abdampfen von flüchtigen Komponenten zu reduzieren bzw. zu minimieren. In bestimmten Phasen des Prozesses können in diesen Prozessraum zusätzliche Prozessgase (z. B. H₂, N₂, Ar, H₂S, H₂Se, S-Gas, Se-Gas und/oder andere) eingeführt werden. Dies kann mit einer Einrichtung zum Ausbilden eines reduzierten Kammerraums realisiert werden, z. B. einer Prozessbox oder einer Prozesshaube. Die Vorrichtung zum Positionieren ist derart ausgebildet, dass sie in der Prozessbox oder Prozesshaube anordenbar oder angeordnet ist.

Eine ausreichende Se-Menge ist nötig, um eine vollständige Selenisierung des metallischen (z. B.) CulnGa-Precursors zu gewährleisten. Se-Verlust würde zu einer unvollständigen Umwandlung des Precursors zum Chalkopyrit-Halbleiter und somit zu deutlichem Leistungsverlust des Solarmoduls führen. Die Gewährleistung einer ausreichenden Se-Menge erfolgt z. B. durch den Einsatz der Prozessbox. Entsprechendes gilt für andere derartige Prozesse. Prozessboxen lassen sich offen oder auch geschlossen gestalten. Bei offenen Boxen sind keine oder nur teilweise Seitenwände vorhanden. Bei geschlossenen Boxen umschließen ein Bodenelement, ein Deckelelement und Seitenwände den Prozessraum im Wesentlichen vollständig. Prozesshauben sind in der Regel zum stationären Verbleib in der Prozessieranlage ausgebildet.

In einer bevorzugten Ausführungsform ist die Vorrichtung derart ausgebildet, dass die Mehrschichtkörper im Gebrauch sandwichförmig übereinanderliegend angeordnet sind und so einen unteren Mehrschichtkörper und einen oberen Mehrschichtkörper der Mehrschichtkörperanordnung ausbilden. Damit ist die Beschichtung bzw. die zu prozessierende Oberfläche obenliegend auf dem unteren Substrat und untenliegend auf dem oberen Substrat (Face-to-Face- oder Head-to-Head-Anordnung) angeordnet.

Vorzugsweise ist die Vorrichtung derart in dem Kammerraum der Prozesskammer anordenbar (oder an einer geeigneten bzw. dafür vorgesehenen Stelle), bzw. die Vorrichtung ist derart ausgebildet, dass die zwei Mehrschichtkörper derart an dieser anordenbar sind, dass diese und/oder die Vorrichtung zum Positionieren mindestens teilweise die Einrichtung zum Ausbilden eines reduzierten Kammerraums, vorzugsweise die Prozessbox, ausbilden. Je nach Ausgestaltung können also die Mehrschichtkörper bzw. die Substrate die Prozessbox ausbilden und ohne oder auch mit zusätzlichen Seitenwänden zusammenwirken. Auch kann die Vorrichtung zum Positionieren Teile (z. B. mindestens Teile der Seitenwände) der Prozessbox mit ausbilden. In diesem Falle würde der reduzierte Kammerraum, also der Prozessraum, dann im Wesentlichen dem Raum zwischen den Mehrschichtkörpern entsprechen. So kann z. B. auf eine explizite Prozessbox verzichtet werden.

Die Nutzung der Substrate und/oder der Vorrichtung zum Positionieren als Bestandteile der Prozessbox hat den Vorteil, die Prozessgase nur dort zuführen zu können, wo sie auch gebraucht werden. Somit ist eine Verringerung bzw. Vermeidung der eventuell auftretenden Rückseitenbeschichtung während der Prozessierung möglich. Durch die spezielle Anordnung der Substrate sind diese während der Prozessierung, also z. B. während der Selenisierung, nicht mehr innerhalb einer Prozessbox und somit außerhalb der Prozessgas-Umgebung angeordnet. Die Substrat-Rückseiten sind somit keiner Se- bzw. S-Atmosphäre mehr ausgesetzt. Das heißt, nur die zu prozessierenden Seiten bzw. Oberflächen sind dem Prozessgas ausgesetzt.

Ist eine Prozessbox zum Reduzieren des Kammerraums vorgesehen, so kann die erfindungsgemäße Vorrichtung zum Positionieren unmittelbar in dieser angeordnet werden. Letztendlich lässt sich die Prozessbox dann mit der Mehrschichtkörperanordnung in die Prozessieranlage befördern (z. B. mittels des ggf. beweglichen Carriers oder auch manuell). Es ist auch möglich, die Mehrschichtkörperanordnung außerhalb der Anlage "zusammenzubauen" und erst dann in die Kammer einzubringen (z. B. mittels des Carriers). Das heißt, die Vorrichtung ist auf dem Carrier angeordnet, so dass sich die zusammengebaute Mehrschichtkörperanordnung mittels der Transportvorrichtung in die Anlage einfahren lässt. Die Prozesskammer der Anlage könnte dann z. B. die oben beschriebene Prozesshaube aufweisen, so dass mit einem reduzierten Kammerraum gearbeitet werden kann.

Die (explizite) Einrichtung zur Ausbildung eines reduzierten Kammerraums und/oder die Vorrichtung zum Positionieren (die ggf. zum Teil die Einrichtung mit ausbildet) sind vorzugsweise derart ausgebildet, dass der aus Bodenelement und/oder unterem Substrat bzw. Deckelelement und/oder oberem Substrat gebildete (reduzierte) Raum ein geeignetes Volumen hat: er darf nicht zu groß sein, damit nicht zu viel Chalcogenmenge (Se oder S) oder ggf. auch flüchtige Reaktionsprodukte verdampfen (abzuschätzen aus dem Gleichgewichts-Dampfdruck bei Prozesstemperatur), aber auch nicht zu klein, damit bei temporären Verbiegungen des Substrats im Aufheizprozess die Substrate nicht die gegenüberliegende Gegenplatte berühren. Der Abstand zwischen Gegenplatte und Substrat sollte z. B. jeweils etwa zwischen 1 und 20 mm betragen. Grundsätzlich wäre jedoch auch unmittelbarer Kontakt zwischen Substrat und Gegenplatte möglich.

Damit die Strahlung der Energiequellen bis zu den zu prozessierenden Oberflächen durchdringen kann, sind (wie bereits oben angedeutet) die dazwischenliegenden Elemente, wie z. B. Bodenelement und Deckelelement der Prozessbox oder auch die Prozesshaube mindestens teiltransparent ausgebildet, je nach Ausgestaltung der Energiequellen. Zwischen den Substraten und den Strahlungsquellen müssen also (sofern die Energiequellen-Anordnung diese erfordert) etwaige Elemente als teiltransparente oder transparente Scheiben (z. B. aus Glaskeramik) oder als für die gewählte Energiequelle hoch absorbierende Scheiben, die als sekundäre Energiequelle bzw. als Energietransmitter fungieren, ausgebildet sein. Sind die Quellen z. B. im Inneren der Prozesskammer (ggf. auch im Inneren der Prozessbox oder -haube) angeordnet, und liegt auch die Mehrschichtkörperanordnung z. B. in der Prozesskammer, so kann die Kammerwandung (Seitenwände, Deckel und/oder Boden) auch nicht-transparent ausgebildet sein. Als Material von Boden- und Deckelelement und von ggf. vorhandenen Seitenwandelementen (bei expliziter Prozessbox) oder der Prozesshaube kann bzw. können z.B. Glaskeramik, andere Keramiken, Graphit, Metalle und hochschmelzende Gläser (Auswahl) vorgesehen sein. Auch Siliziumcarbid kann hierfür vorgesehen sein. Auch ein Carrier sollte mindestens teilweise aus teiltransparentem oder hoch absorbierendem Material ausgebildet sein, da er während des Prozessierens in der Anlage verbleiben kann.

Vorzugsweise weist die Vorrichtung zum Positionieren mindestens ein erstes Beabstandungselement auf, das zur Aufnahme des oberen Mehrschichtkörpers und/oder des unteren Mehrschichtkörpers ausgebildet ist, wobei das Beabstandungselement derart mindestens teilweise zwischen den zwei Mehrschichtkörpern anordenbar ist, dass diese beabstandet voneinander anordenbar oder angeordnet sind und so die Mehrschichtkörperanordnung ausbilden. Das Beabstandungselement muss so ausgebildet sein, dass die zu prozessierenden Oberflächen frei für das Prozessgas zugänglich sind, gleichzeitig müssen die Oberflächen derart beabstandet sein, dass sie einen geeigneten Prozessraum ausbilden. Wenn kein Prozessgas zusätzlich zugeführt werden soll oder muss, ist auch ein direkter Kontakt der zu prozessierenden Oberflächen denkbar. Auch dann kann von einem Prozessraum zwischen den zu prozessierenden Oberflächen gesprochen werden.

Da die Mehrschichtkörper vorzugsweise sandwichförmig und damit im Gebrauch horizontal angeordnet sind, lässt sich der obere Mehrschichtkörper auf dem Beabstandungselement ablegen (wird also von dem Beabstandungselement an einem oberen Aufnahmebereich aufgenommen). Der untere Mehrschichtkörper liegt auf dem Beabstandungselement an einem unteren Aufnahmebereich an (das Anlegen wird also auch als Aufnehmen durch das Beabstandungselement verstanden), wobei der untere Aufnahmebereich an einer Seite des Beabstandungselements angeordnet ist, die entgegengesetzt der Seite mit dem oberen Aufnahmebereich liegt.

In einer vorteilhaften Ausführungsform weist die Vorrichtung zum Positionieren mindestens ein zweites Beabstandungselement auf, das zur Aufnahme des oberen Mehrschichtkörpers und/oder des unteren Mehrschichtkörpers und zur Aufnahme des ersten Beabstandungselements ausgebildet ist, derart, dass das zweite Beabstandungselement, der untere Mehrschichtkörper, das erste Beabstandungselement und der obere Mehrschichtkörper sandwichförmig anordenbar oder angeordnet sind und so die Mehrschichtkörperanordnung ausbilden. Mit dieser Ausgestaltung lässt sich jeder der Mehrschichtkörper tragend durch eines der Beabstandungselemente anordnen, wobei die Beabstandungselemente dann übereinander stapelbar sind. Das heißt, das untenliegende zweite Beabstandungselement wird vor dem Prozess an einer geeigneten Stelle platziert (in der Prozesskammer oder -box, auf dem Carrier etc.) und zuerst mit dem untenliegenden Substrat bzw. Mehrschichtkörper beladen, Precursor-Schichtseite nach oben, danach wird das erste Beabstandungselement aufgesetzt, gefolgt von der Beladung mit dem obenliegenden Substrat bzw. Mehrschichtkörper, Precursor-Schichtseite nach unten (Beladung zur Ausbildung einer Mehrschichtkörperanordnung). Diese Anordnung erleichtert den Zusammenbau einer Mehrschichtkörperanordnung. Die Entladung nach der Prozessierung erfolgt entsprechend in umgekehrter Reihenfolge. Das erste Beabstandungselement lässt sich grundsätzlich auch so ausgestalten, dass es nicht auf dem zweiten Beabstandungselement aufliegt, sondern ebenfalls auf der "geeigneten Stelle", also z.B. auf dem Carrier. Die Unterseite (Unterseite im Gebrauch) des untenliegenden zweiten Beabstandungselements kann bei diesem Konzept auch als Auflagefläche zum Transport (z. B. durch Rollenantrieb) dienen. Das zweite oder untere Beabstandungselement kann auch selbst die Funktion eines Carriers übernehmen. Die Beabstandungselemente können auch als Auflageelemente bezeichnet werden, das erste Beabstandungselement als erstes Auflageelement, das zweite Beabstandungselement als zweites Auflageelement. Auflageelemente deshalb, weil die Substrate bzw. Mehrschichtkörper an diesen anliegen bzw. aufliegen. Vorzugsweise ist das zweite Beabstandungselement im Gebrauch mindestens teilweise unter dem unteren Mehrschichtkörper anordenbar. Somit ist ein sicherer Halt des Substrats gewährleistet. In einer vorteilhaften Ausführungsform weisen das erste Beabstandungselement und das zweite Beabstandungselement jeweils mindestens einen Auflagebereich auf, auf welchen oder an welchen der oder die Mehrschichtkörper auflegbar oder anlegbar ist oder sind. Beim Lagern der Substrate ist darauf zu achten, dass die beschichteten Seiten möglichst wenig berührt werden, um eine Kontamination durch Berühren oder die Störung der Prozessgasatmosphäre an der Kontaktfläche zu vermeiden (damit die Schichtqualität des entstehenden Absorbers nicht lokal oder integral beeinträchtigt wird). Diese Anforderung wird zum Teil dadurch erleichtert, dass z. B. 15 mm des Randbereichs von jeder Kante in einem späteren Prozessschritt sowieso entfernt werden und daher nicht zur aktiven Schicht gehören.

Vorzugsweise weisen das erste Beabstandungselement und/oder das zweite Beabstandungselement jeweils mindestens ein Rahmenelement und/oder ein Rahmenleistenelement auf, so dass die Mehrschichtkörper vorzugsweise an deren Kantenbereichen (am Rand) mindestens teilweise auf das Rahmenelement und/oder das Rahmenleistenelement auflegbar oder an das Rahmenelement und/oder das Rahmenleistenelement anlegbar sind. Die Rahmenelemente bzw. Rahmenleistenelemente ermöglichen einen möglichst geringen Kontakt der Mehrschichtkörper, also z. B. der Substrate, mit diesen (also mit den Rahmenelementen), um die zu prozessierenden Oberflächen möglichst frei zu halten. Eine vorteilhafte Ausführungsform sieht vor, dass die zwei Mehrschichtkörper und das erste Beabstandungselement oder die zwei Mehrschichtkörper und das erste Beabstandungselement und das zweite Beabstandungselement derart zueinander angeordnet sind, dass sie einen im Wesentlichen geschlossenen, also quasi-geschlossenen Prozessraum ausbilden, im Sinne einer Abgrenzung von reaktiver Dünnschicht und Ofenumgebung bzw. Kammerraum. Das heißt, die Substrate bilden Deckelelement und Bodenelement einer Prozessbox, während das oder die Beabstandungselemente z.B. als Seitenwandelemente der Prozessbox vorgesehen sind. Das Mehrschichtkörper-Sandwich stellt in diesem Fall ein Analogon zu einer expliziten Prozessbox dar. Der Prozessraum ist damit in gewünschter Weise reduziert, lediglich die zu prozessierenden Oberflächen werden dem Prozessgas ausgesetzt. In dieser dargelegten Prozess-Variante wird versucht, durch eine Minimierung der Kammer-Umgebung einen ausreichend hohen (z. B.) Se-Partialdruck auch ohne Einsatz einer expliziten Prozessbox zu gewährleisten.

Meist sind die Mehrschichtkörper rechteckförmig oder quadratisch ausgebildet. Vorzugsweise sind dann auch das erste Beabstandungselement und/oder das zweite Beabstandungselement vorzugsweise im Wesentlichen die Konturen der Mehrschichtkörper nachbildend ebenfalls rechteckförmig oder quadratisch ausgebildet und weisen so jeweils mindestens ein rechteckförmig oder quadratisch ausgebildetes Rahmenelement auf. Mit dieser Ausgestaltung liegen die Substrate dann an ihren Kanten auf den jeweiligen Rahmenelementen auf, so dass die zu beschichtenden bzw. die zu prozessierenden Oberflächen frei bleiben. Es ist darauf zu achten, dass die Mehrschichtkörper über eine ausreichend große Auflagefläche auf dem Beabstandungselement aufliegen bzw. an diesem anliegen.

In einer weiteren Ausführungsform weisen das erste Beabstandungselement und/oder das zweite Beabstandungselement zwei Rahmenleistenelemente (Leisten) auf, die sich in einer Erstreckungsebene der Mehrschichtkörper im Gebrauch gegenüberliegen, so dass die Mehrschichtkörper vorzugsweise an deren Kantenbereichen, z. B. an deren Längsseiten, mindestens teilweise auf die Rahmenleistenelemente auflegbar oder an die Rahmenleistenelemente anlegbar sind, so dass z.B. an den Querseiten der Mehrschichtkörperanordnung jeweils mindestens ein Öffnungsbereich zum Zuführen und/oder Abführen des Prozessgases in den und/oder aus dem Prozessraum ausgebildet ist. Die Anordnung kann auch umgekehrt ausgeführt sein, d. h. an den Längsseiten der Mehrschichtkörperanordnung ist jeweils mindestens ein Öffnungsbereich zum Zuführen und/oder Abführen des Prozessgases in den und/oder aus dem Prozessraum ausgebildet. Das heißt, es liegen sich vorzugsweise mindestens zwei Öffnungsbereiche gegenüber, an denen keine Rahmenleistenelemente vorgesehen sind. Bei quadratisch ausgebildeten Substraten wird nicht zwischen Längs- und Querseiten unterschieden.

Möglich ist es auch, die Rahmenleistenelemente derart auszubilden, dass sie sich jeweils um mindestens zwei sich diagonal gegenüberliegende Ecken der Mehrschichtkörperanordnung erstrecken. Die übrigen offenen Bereiche, die dann sowohl an den Längs- als auch an den Querseiten der Anordnung vorgesehen sind, dienen dem Gasaustausch. Der so gebildete Prozessraum ist ein quasi-offener und ermöglicht eine schnelle Prozessgaszu- oder auch -abfuhr. Mit quasioffen ist in diesem Zusammenhang also das Ermöglichen eines partiellen Gasaustauschs zwischen Substrat-Umgebung und Ofen (-Kammer)-Umgebung gemeint.

Wie bereits oben beschrieben, sollen die Mehrschichtkörper mindestens teilweise auf den Auflagebereichen der Beabstandungselemente aufliegen oder an diesen anliegen. Sofern die Mehrschichtkörper entlang ihren Konturen vollständig aufliegen, lässt sich ein im Wesentlichen geschlossener Prozessraum ausbilden. Bei teilweisem Aufliegen sind Öffnungsbereiche vorgesehen, die einen Austausch des Prozessgases mit der Atmosphäre im Kammerraum ermöglicht. Bei Rahmenleistenelementen, die z. B. nur an den Längsseiten der Substrate angeordnet sind, sind diese Öffnungsbereiche ohnehin gegeben. Verschiedene Ausführungsformen sind also vorstellbar, die zu einem quasi-offenem Rahmen führen. Die Variante "quasi-offener Prozessraum" ist insbesondere für das Tunnel- und Hauben-Konzept der RTP-Prozessierung von Interesse (Prozessgas-Zufuhr zu den Precursorschichten als den zu prozessierenden Oberflächen des Substrat-Sandwichs in der Haube bzw. im Tunnel).

Bei einer Anordnung der Rahmenelemente oder Rahmenleistenelemente an den Mehrschichtkörperkanten bzw. Substratkanten entlang der Transportrichtung ist es denkbar, die Rahmenelemente oder Rahmenleistenelemente derart zu gestalten, dass eine Führung des Substrat-Sandwichs in Transportrichtung erfolgen kann.

Insbesondere bei quasi-geschlossenen Systemen muss eine andere Möglichkeit zum Zu- und Abführen des Prozessgases vorgesehen werden. Im RTP-Prozess können z. B. die Prozessgase H₂, N₂, Ar, H₂S, H₂Se, S-Gas, Se-Gas eingesetzt und zu gezielten Prozesszeiten ins Ofeninnere also in den Kammerraum bzw. ins Innere der Prozessbox eingeleitet werden. Möglich ist es also auch, den Sulfurisierungsprozess mit gasförmigem Schwefel (S) bzw. den Selenisierungsprozess mit gasförmigem Selen (Se) durchzuführen. Um die Prozessgas-Zufuhr zum Dünnschicht-Precursor (also den Mehrschichtkörper) im hier dargelegten Aufbau während des RTP-Prozesses zu ermöglichen, wird eine Prozessgas-Zufuhr über den Rahmen vorgeschlagen. Im Selenisierungsprozess wird das im Precursor vorliegende Selen unter Prozessgasatmosphäre umgewandelt, so dass die gewünschte Halbleiterstruktur erhalten wird. Möglich ist es auch, zusätzlich Selen im Prozessgas vorzusehen (Se-Gas), je nach gewünschtem Ergebnis. Die Umwandlung des Precursor-Selens ist aber auch ohne explizites Selen im Prozessgas möglich. Vorzugsweise weisen daher das erste Beabstandungselement und/oder das zweite Beabstandungselement ein Gaszufuhrelement und/oder Gasabfuhrelement zum Zuführen und/oder Abführen eines Prozessgases in den und/oder aus dem Prozessraum auf. Das Gaszufuhrelement bzw. Gasabfuhrelement kann beispielsweise als ein in das erste Beabstandungselement und/oder das zweite Beabstandungselement integrierter Gasverteiler-Kamm mit mindestens einem Anschlusselement zum Anschließen einer Gaszuführleitung und/oder Gasabführleitung ausgebildet sein. In diesem Falle erfolgt die Prozessgaszufuhr (und auch -abfuhr) also über das oder die Beabstandungselemente (partieller bzw. anpassbarer Gasaustausch zwischen Ofenumgebung (z. B. Hauben-, Tunnelumgebung) und Precursor-Dünnschicht). Die Ausbildung des Kammes und der Andockelemente bzw. -stößel lässt sich variabel gestalten, beispielsweise hinsichtlich der Anzahl der Gasauslässe ("Kammzähne"). So kann das entsprechende Beabstandungselement z. B. hohl und mit Öffnungen für den Gasauslass (oder -einlass) ausgebildet sein. Über das Anschlusselement (oder die Anschlusselemente) sind dann entsprechende Leitungen anschließbar, über die das Gas zugeführt oder auch wieder abgeführt werden kann. An sich können die Gasverteiler auch anderweitig an der Kammer und/oder der Prozessbox bzw. -haube angeordnet werden. Wichtig ist es, ein im Wesentlichen homogenes Einleiten des Prozessgases von einer Gasquelle, z. B. einer externen Gasquelle, hin zu den Substraten (über die Prozesskammer oder den Prozesstunnel oder unter Umgehung der Prozesskammer oder des Prozesstunnels nur in eine ggf. vorhandene Prozessbox oder -haube) zu ermöglichen, so dass es zu einer möglichst laminaren Gasströmung über die Substratoberfläche von z. B. einer Längskante zur anderen kommt. Die Gaszufuhr kann an vorgegebenen Einlässen der Gasverteiler zu beliebigen Zeiten des Temperprofiles gesteuert werden. Verbrauchte Mengen des Prozessgases können so nachgeladen werden und/oder nicht mehr erwünschter überschüssiger (z. B.) Selendampf (und/oder sonstige Komponenten des Dampfes) kann aus der Reaktionskammer zum richtigen Zeitpunkt verdrängt werden. Während der RTP-Prozessierung muss ggf. mit einer Substratverbiegung gerechnet werden, da insbesondere das obenliegende Substrat quasi schwebend gelagert ist (wenn es nicht unmittelbar auf dem unteren Substrat aufliegt). Es ist vorstellbar dass es bei hohen Prozess-Temperaturen zu Durchbiegungen kommt, die sich nach der Prozessierung in Substratverbiegungen manifestieren. In einer vorteilhaften Ausgestaltung weisen daher das erste Beabstandungselement und/oder das zweite Beabstandungselement jeweils mindestens ein Querverbindungselement auf, zum Verbinden von, in der Erstreckungsebene der Mehrschichtkörper sich gegenüberliegenden Bereichen des jeweiligen Rahmenelements oder von sich im Gebrauch gegenüberliegenden Rahmenleistenelementen, so dass der oder die Mehrschichtkörper zur Vermeidung einer Durchbiegung zusätzlich abstützbar ist oder sind. Die Querstreben dienen zugleich der Stabilisierung des Rahmens bzw. des Rahmenelements oder der Rahmenleistenelemente. Beim Design der Querstreben bzw. Querverbindungselemente ist auf eine minimale Breite zu achten (jedoch ausreichend, um die gewünschte Stabilität zu gewährleisten), um eine Abschattung der Strahlung der (Heiz-)Strahler bzw. der Energiequellen zu minimieren. Da das Querverbindungselement sich im Wesentlichen "quer" über die zu prozessierende Oberfläche ziehen kann, sollte der Kontakt zwischen Querverbindungselement und Oberfläche möglichst gering gehalten werden. Hierfür kann das Querverbindungselement mindestens ein Abstützelement aufweisen, so dass die Mehrschichtkörper auf dem oder an dem Querverbindungselement über das Abstützelement auflegbar oder anlegbar sind, wobei das Abstützelement derart ausgebildet ist, dass es dieselbe Höhe wie das jeweilige mindestens eine Rahmenelement oder Rahmenleistenelement aufweist (planes Aufliegen der Substrate auf dem oder den Rahmen(leisten)element(en) und dem Abstützelement). Vorzugsweise ist das Abstützelement als Punktstützenelement, vorzugsweise als Kugelelement ausgebildet. Somit ist eine möglichst kleine Auflagefläche oder auch Anlagefläche gewährleistet. Eine noch geringere Abschattung wird durch nadelförmige Elemente erreicht. In einer bevorzugten Ausgestaltung der Erfindung weist das mindestens eine Rahmenelement oder Rahmenleistenelement (bzw. weisen die Rahmenleistenelemente) mindestens zwei Abstützelemente derart auf, dass die Mehrschichtkörper auf den oder an den Abstützelementen auflegbar oder anlegbar sind, so dass an den Querseiten und/oder Längsseiten der Mehrschichtkörperanordnung jeweils mindestens ein Öffnungsbereich zum Zuführen und/oder Abführen des Prozessgases in den und/oder aus dem Prozessraum ausgebildet ist. Das heißt, auch an dem Rahmenelement oder dem Rahmenleistenelement kann der Auflagebereich reduziert werden, wenn diese(s) mit den Abstützelementen ausgebildet ist bzw. sind. Dieser Ansatz führt wiederum zu einem quasi-offenen Rahmendesign mit den bereits oben aufgeführten Kombinationsmöglichkeiten mit dem Tunnel- oder Hauben-RTP-Konzept (Prozessgas-Zufuhr durch die Umgebung). Denkbare Vorteile dieses Abstützelement-Konzepts, also z. B. eines Punktstützenelement-Konzepts, gegenüber dem oben beschriebenen Rahmenelementen bzw. Rahmenleistenelementen ohne Abstützelemente sind die geringere Kontaktflächen mit den Substraten und damit eine Verringerung evtl. auftretender lokaler Störungen. Zudem ist eine Verringerung von Substratverbiegung durch die Einbringung von Stützpunkten im Substrat-Inneren gegeben.

Vorzugsweise ist das erste und/oder zweite Beabstandungselement aus Graphit oder Quarzglas ausgebildet, auch Glaskeramik, andere Keramiken und hochschmelzende Gläser sind denkbar. Das Rahmenmaterial sollte inert sein, beständig in korrosiver Umgebung (S-, Se-haltig) und mechanisch stabil. Aufgrund des direkten Kontaktes mit den Substraten sind auch die Wärmeleitfähigkeit und der thermische Ausdehnungskoeffizient zu betrachten, um laterale Inhomogenitäten der Temperaturverteilung auf dem Substrat weitestgehend zu vermeiden und Schichtabplatzungen bzw. Schädigungen zu verhindern. Rahmenmaterial und auch Abstützelemente können aus Graphit oder Quarzglas, Glaskeramik, andere Keramiken oder hochschmelzenden Gläsern ausgebildet sein (z. B. Graphitkugeln). Auch bei der Auswahl des Materials für die Punktstützen ist auf folgende Materialeigenschaften zu achten: inertes Material, Korrosionsbeständigkeit, mechanische Stabilität, thermische Leitfähigkeit und thermischer Ausdehnungskoeffizient. Der Einsatz von z. B. Graphit-Kugeln in Kombination mit einem Graphit-Rahmenelement bzw. -Rahmenleistenelement ist beispielsweise denkbar.

Gemäß vorliegender Erfindung wird selbstständiger Schutz beansprucht für eine Mehrschichtkörperanordnung, umfassend mindestens zwei Mehrschichtkörper mit jeweils mindestens einer zu prozessierenden Oberfläche, und mindestens eine Vorrichtung zum Positionieren der mindestens zwei Mehrschichtkörper, so wie sie oben beschrieben ist. Hierbei sind die mindestens zwei Mehrschichtkörper derart angeordnet, dass sich die jeweils zu prozessierenden Oberflächen gegenüberliegen und die Mehrschichtkörper, so einen zwischen den Oberflächen angeordneten quasi-geschlossenen Prozessraum ausbilden, in dem im Wesentlichen die Prozessierung erfolgt. Mit dieser Anordnung kann auf eine explizite Vorrichtung zum Positionieren verzichtet werden, vielmehr liegen die Substrate mit ihren zu prozessierenden Oberflächen aufeinander, z. B. in der Prozessbox oder auch in der Prozesskammer. Diese Anordnung ist insbesondere dann geeignet, wenn kein Prozessgas für die Prozessierung in den Raum zwischen den zu prozessierenden Oberflächen zugeführt werden muss. Die Vorrichtung zum Positionieren ist in die Prozesskammer einführbar und aus dieser wieder entfernbar. Die Mehrschichtkörperanordnung ist zweckmäßigerweise außerhalb der Prozessieranlage aufzubauen und anschließend in die Anlage zu transportieren oder auch manuell einzubringen, damit sie dort dem gewünschten Prozess (z. B. der Selenisierung der Substrate) unterzogen werden kann. Möglich ist es auch, die Vorrichtung zum Positionieren derart in der Prozesskammer anzuordnen, dass sich in dieser die Mehrschichtkörperanordnung aufbauen lässt. Auch können die Mehrschichtkörper ohne die Vorrichtung angeordnet werden. Nach der Umwandlung der Substrate zu den gewünschten Chalkopyrit-Halbleitern ist die Anordnung im Gesamten aus dem Kammerraum entfernbar oder die Einzelteile sind entnehmbar.

Selbstständiger Schutz wird auch beansprucht für eine Anlage zum Prozessieren, insbesondere zum Selenisieren, von mindestens zwei mindestens zwei Mehrschichtkörpern, mit jeweils mindestens einer zu prozessierenden Oberfläche, umfassend mindestens eine Prozesskammer mit einem Kammerraum (oder auch Tunnel mit Tunnelraum), und eine Vorrichtung zum Positionieren der mindestens zwei Mehrschichtkörper, so wie sie oben beschrieben ist. Vorzugsweise weist die Anlage mindestens eine Energiequelle zum Aufheizen der Mehrschichtkörper auf. Vorzugsweise ist die Energiequelle derart an der Prozesskammer bzw. in der Prozessieranlage angeordnet, dass jeder der Mehrschichtkörper jeweils von der Seite aus beheizt wird, die der zu prozessierenden Oberfläche abgewandt angeordnet ist (Substratrückseite(n)). Hierfür können z. B. zwei Energiequellen vorgesehen sein, eine für den unteren Mehrschichtkörper, eine für den oberen Mehrschichtkörper (das heißt, mindestens jeweils eine Energiequelle ist für jeden der Mehrschichtkörper vorgesehen). Damit lassen sich die Mehrschichtkörper, also z. B. die Substrate, über ihre Rückseiten aufheizen, also über die Seiten, die jeweils den zu prozessierenden Oberflächen abgewandt angeordnet sind.

Die Ausgestaltung der Energiequellen ist variierbar. Wie bereits oben beschrieben, erfolgt die Aufheizung der Substrate bzw. der Mehrschichtkörper im Wesentlichen nur einseitig durch das Heizen der jeweiligen Mehrschichtkörperrückseite bzw. Glasrückseite. Das obere Substrat wird nur von oben, das untere wird nur von unten geheizt. Eine direkte Aufheizung der sich gegenüberliegenden beschichteten Oberflächen findet nicht statt. Demgemäß muss bei der Wahl der Energiequelle darauf geachtet werden, dass ausreichend Wärme an den zu prozessierenden Oberflächen zur Verfügung steht (Aufheizrate), denn der Teil des Spektrums der Strahlungsquelle, der schon im Substratglas absorbiert wird, erreicht die Schicht erst durch Wärmeleitung etwas verzögert. Je höher der Anteil der Leistung der erst im Molybdän absorbiert wird, desto größer sind die erreichbaren Aufheizraten. Das Substratglas absorbiert z. B. bei Wellenlängen oberhalb ca. 1,5 µm und unterhalb 350 nm. Durch einseitiges Aufheizen könnte die Scheibe brechen oder eine übermäßige Verbiegung aufweisen. Da die Dicke des Glases nur 2-3 mm beträgt und ein großer Anteil der Strahlung erst im Mo absorbiert wird, ist nicht zu erwarten, dass bei Aufheizraten im Bereich von einigen K/s vertikale Gradienten im Glas aufgebaut werden können. Viel wichtiger für geringe Bruchraten ist die laterale Homogenität des Aufheizens (in der Substratfläche). Entsprechend ist die Energiequelle vorzusehen. Auch beim Abkühlen ist es erfahrungsgemäß sehr wichtig, die laterale Homogenität zu optimieren. Bei den in dieser Anordnung erreichbaren Abkühlraten, ist es nicht zu erwarten, dass Spannungen im Glas durch vertikale Gradienten zwischen Schichtseite (also beschichteter Seite) und Rückseite entstehen können.

Eine bevorzugte Ausgestaltung sieht vor, dass mindestens eine Einrichtung zum Ausbilden eines reduzierten Kammerraums vorgesehen ist, die in der Prozesskammer anordenbar oder angeordnet ist, vorzugsweise eine Prozessbox oder eine Prozesshaube. Derartige Einrichtungen reduzieren den eigentlichen Raum, der für die Prozessierung zur Verfügung steht und bilden einen expliziten Prozessraum aus. Vorteilhafterweise weist die Prozessbox mindestens ein Deckelelement und mindestens ein Bodenelement auf, zwischen welchen die mindestens zwei Mehrschichtkörper anordenbar sind. In diesem Falle kann der untere Mehrschichtkörper auf dem Bodenelement aufgelegt werden, auf diesen wird dann zumindest ein Beabstandungselement, vorzugsweise ein Rahmenelement oder zwei Rahmenleistenelemente aufgelegt und auf das Beabstandungselement wiederum der obere Mehrschichtkörper. Mittels des Deckelelements wird die Prozessbox verschlossen. Damit ist die Mehrschichtkörperanordnung definiert in der Prozesskammer der Anlage untergebracht. Mit zusätzlichen Seitenwandelementen kann die Prozessbox im Wesentlichen vollständig geschlossen werden. Etwaige offene Bereiche könnten dem Gasaustausch dienen. Die Prozessbox ist in die Prozesskammer einführbar und aus dieser wieder entfernbar.

Die Einrichtung zum Ausbilden eines reduzierten Kammerraums kann auch als Prozesshaube ausgebildet sein. Dabei ist die Prozesshaube z. B. als stationär in der Behandlungskammer angeordneter Deckel ausgebildet. Der Gasaustausch zwischen Prozessraum und Kammerraum ist daher deutlich reduzierbar. Auch kann der Prozessraum unter Umgehung des Kammerraums unmittelbar mit einer (z.B. externen) Gasquelle in Verbindung stehen.

Wie bereits oben beschrieben, kann die Prozessbox zumindest teilweise auch durch die Mehrschichtkörperanordnung ausgebildet werden. Die Materialien sind wie z. B. oben beschrieben gewählt.

Verfahrensmäßig wird die oben genannte Aufgabe durch ein Verfahren zum Prozessieren von mindestens zwei Mehrschichtkörpern mit jeweils mindestens einer zu prozessierenden Oberfläche gelöst. Bei dem Verfahren werden die beiden Mehrschichtkörper derart angeordnet, dass sich die jeweils zu prozessierenden Oberflächen gegenüberliegen und so einen zwischen den Oberflächen angeordneten, quasi-geschlosenen Prozessraum ausbilden, in dem die Prozessierung erfolgt. Vorzugsweise ist der weitere Schritt vorgesehen: Anordnen der Vorrichtung in einer Prozesskammer oder einem Prozesstunnel der Prozessieranlage mit einem Kammerraum und/oder in einer Einrichtung zum Ausbilden eines reduzierten Kammerraums und/oder auf oder an einem Tragelement zum Transportieren der Mehrschichtkörperanordnung mittels einer Transportvorrichtung in die Prozessieranlage (d. h. in die Prozesskammer oder in den Prozesstunnel) und aus dieser heraus oder an einer sonstigen geeigneten Stelle. In einer vorteilhaften Ausgestaltung des Verfahrens kann der Schritt des Anordnens der Vorrichtung folgendermaßen vorgesehen sein:
- Anordnen in einer Prozessbox mit einem Bodenelement, einem Deckelelement und vorzugsweise mit Seitenwandelementen als die Einrichtung zum Ausbilden eines reduzierten Kammerraums oder
- Anordnen innerhalb bzw. unter einer Prozesshaube, die insbesondere zum stationären Verbleib in der Prozessieranlage ausgebildet ist, als die Einrichtung zum Ausbilden eines reduzierten Kammerraums.

Vorzugsweise umfasst das Verfahren den Schritt des Anordnens der zwei Mehrschichtkörper im Gebrauch an der Vorrichtung zum Positionieren sandwichförmig übereinanderliegend, so dass ein unterer Mehrschichtkörper und ein oberer Mehrschichtkörper vorgesehen sind. Die im Gebrauch "horizontal" liegenden Körper können so am gleichmäßigsten und am sichersten prozessiert werden. Vorzugsweise ist der weitere Schritt vorgesehen: Anordnen der zwei Mehrschichtkörper derart an der Vorrichtung oder in dem Kammerraum der Prozesskammer bzw. im Tunnel der Prozessieranlage (oder an einer sonstigen dafür vorgesehenen Stelle), dass die zwei Mehrschichtkörper und/oder die Vorrichtung zum Positionieren mindestens teilweise die Einrichtung zum Ausbilden eines reduzierten Kammerraums, vorzugsweise eine Prozessbox, ausbilden. In einer vorteilhaften Ausgestaltung umfasst das Verfahren die folgenden weiteren Schritte:
- Anordnen des oberen Mehrschichtkörpers und/oder des unteren Mehrschichtkörpers an einer hierfür vorgesehenen Stelle,
- Anordnen mindestens eines ersten Beabstandungselements, welches von der Vorrichtung zum Positionieren umfasst ist (also Teil der Vorrichtung zum Positionieren ist), derart mindestens teilweise zwischen den zwei Mehrschichtkörpern, dass diese beabstandet voneinander angeordnet sind und so die Mehrschichtkörperanordnung ausbilden.

Weiterhin umfasst das Verfahren in einer vorteilhaften Ausgestaltung folgende zusätzlichen Schritte:
- Anordnen mindestens eines zweiten Beabstandungselements, welches von der Vorrichtung zum Positionieren umfasst ist (also Teil der Vorrichtung zum Positionieren ist), an einer hierfür vorgesehenen Stelle,
- Anordnen des unteren Mehrschichtkörpers an dem zweiten Beabstandungselement,
- Anordnen des ersten Beabstandungselements an dem zweiten Beabstandungselement,
- Anordnen des oberen Mehrschichtkörpers an dem ersten Beabstandungselement,
so dass das zweite Beabstandungselement, der untere Mehrschichtkörper, das erste Beabstandungselement und der obere Mehrschichtkörper sandwichförmig angeordnet sind und so die Mehrschichtkörperanordnung ausbilden.

Das erste Beabstandungselement kann ggf. auch unmittelbar auf der hierfür vorgesehenen Stelle angeordnet werden, z. B. in dem Kammerraum, auf dem Bodenelement einer Prozessbox oder auf einem Carrier. Hierfür müsste das erste Beabstandungselement entsprechend ausgelegt sein.

Wie bereits oben beschrieben, lässt sich die Mehrschichtkörperanordnung außerhalb der Prozessieranlage aufbauen, z. B. in der Prozessbox, die beispielsweise mit dem Tragelement tranportiert wird oder unmittelbar auf dem Tragelement. Mittels des Tragelements lässt sich die Anordnung dann in die Prozessieranlage fahren. Möglich ist es auch, die Anordnung ohne Tragelement zu transportieren, z. B. mit einem Rollenantrieb. Auch das manuelle Einführen der Anordnung (sowohl der einzelnen Bauteile, als auch der gesamten, vorab zusammengebauten Anordnung) in die Prozessieranlage ist möglich. Im Übrigen kann auch das untere Beabstandungselement als Tragelement und/oder Transportelement dienen. Ferner ist es vorgesehen, die positionierten Mehrschichtkörper in die Prozessieranlage einzubringen, zu prozessieren und wieder aus der Anlage zu entfernen. Dies ist z.B. mittels der bereits beschriebenen Transportvorrichtung möglich oder auch manuell.

Ein weiteres Verfahren zum Positionieren von mindestens zwei Mehrschichtkörpern mit jeweils mindestens einer zu prozessierenden Oberfläche umfasst: Anordnen der zwei Mehrschichtkörper derart, dass sich die jeweils zu prozessierenden Oberflächen gegenüberliegen und die Mehrschichtkörper so einen zwischen den Oberflächen angeordneten, quasi-geschlossenen Prozessraum ausbilden, in dem im Wesentlichen die Prozessierung erfolgt, so dass die mindestens zwei Gegenstände als eine Mehrschichtkörperanordnung in einer Prozessieranlage prozessierbar, insbesondere selenisierbar sind. Konkret heißt dies z.B. Anordnen des unteren Mehrschichtkörpers in der Prozesskammer, in der Prozessbox, auf einem Carrier oder an einer sonstigen geeigneten Stelle und Auflegen des oberen Mehrschichtkörpers auf den unteren, so dass sich die zu prozessierenden Oberflächen gegenüberliegen. Von einem Prozessraum kann auch gesprochen werden, wenn die Substrate unmittelbar aufeinander liegen.

Mit den soeben beschriebenen Verfahrensschritten zum Zusammenbau der Mehrschichtkörperanordnung können die Mehrschichtkörper bzw. Substrate präzise gelagert werden, so dass deren Prozessierung in einer entsprechenden Anlage mit hohem Durchsatz und auf effiziente Weise durchgeführt werden kann.

Die Erfindung erstreckt sich weiterhin auf die Verwendung einer wie oben beschriebenen Mehrschichtkörperanordnung, sowie eines wie oben beschriebenen Verfahrens zur Herstellung einer Dünnschichtsolarzelle bzw. -moduls, welche vorzugsweise als Halbleiterschicht eine Chalkopyritverbindung, insbesondere Cu(In,Ga)(S,Se)₂, enthält. Vorzugsweise dient die Verwendung zur Herstellung einer CIS- bzw. (CIGSSe)-Dünnschichtsolarzelle bzw. eines CIS bzw. (CIGSSe)-Dünnschichtsolarmoduls, wobei insbesondere jeder Mehrschichtkörper in Form einer Glasscheibe ausgebildet und mit mindestens den Elementen Cu, In oder Cu, In, Ga oder Cu, In, Ga, Selen zur Selenisierung und/oder Sulfurisierung eines Chalkopyritdünnschichthalbleiters beschichtet ist.

Es versteht sich, dass die verschiedenen Ausgestaltungen der erfindungsgemäßen Gegenstände einzeln oder in beliebigen Kombinationen realisiert sein können. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Nachfolgend wird die Erfindung anhand von Ausführungsbeispielen beschrieben, die anhand der Abbildungen näher erläutert werden. Hierbei zeigen:
- - Fig. 1: eine erfindungsgemäßen Anordnung (prinzipielle Darstellung) in einer perspektivischen Ansicht;
- - Fig. 2: eine Ausführungsform einer Vorrichtung zum Positionieren bzw. Anordnung in einer perspektivischen Ansicht;
- - Fig. 3: ein Beabstandungselement wie in Fig. 2 vorgesehen, in einer perspektivischen Ansicht;
- - Fig. 4: ein weiteres Beabstandungselement in einer perspektivischen Ansicht;
- - Fig. 5: ein weiteres Beabstandungselement in Draufsicht;
- - Fig. 6: ein weiteres Beabstandungselement in einer perspektivischen Ansicht;
- - Fig. 7: das Beabstandungselement gemäß Fig. 2 oder 3 in einer perspektivischen Ansicht;
- - Fig. 8: ein weiteres Beabstandungselement in einer perspektivischen Ansicht;
- - Fig. 9: eine weitere Ausführungsform der Vorrichtung bzw. Anordnung in einer Schnittdarstellung;
- - Fig. 10: eine weitere Ausführungsform der Vorrichtung bzw. Anordnung in einer Schnittdarstellung;
- - Fig. 11: die Ausführungsform der Vorrichtung bzw. Anordnung gemäß Fig. 2 in einer Prozessbox, in einer perspektivischen Ansicht;
- - Fig. 12: eine weitere Ausführungsform der Anordnung in einer Prozesskammer, in einer perspektivischen Ansicht;
- - Fig. 13: eine weitere Ausführungsform der Anordnung in einer Prozesskammer, in einer perspektivischen Ansicht;
- - Fig. 14: eine Anlage zum Prozessieren in einer Schnittdarstellung.

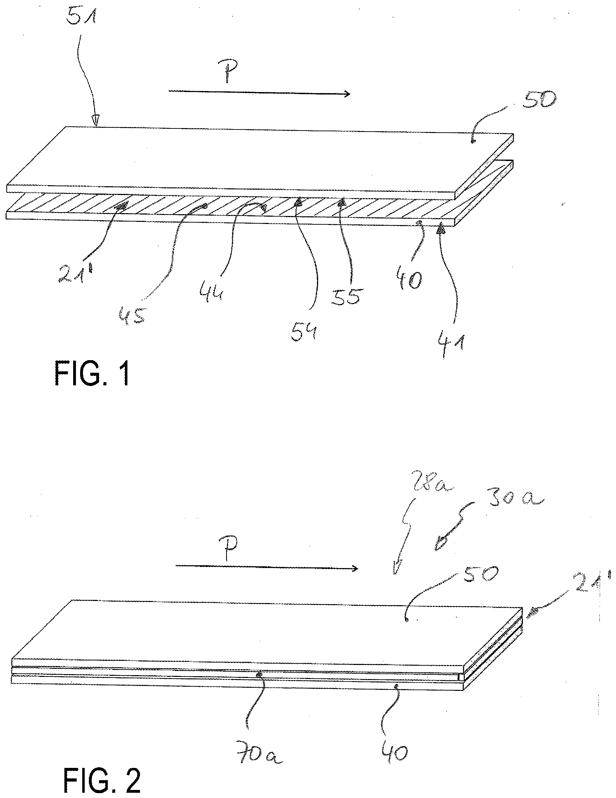

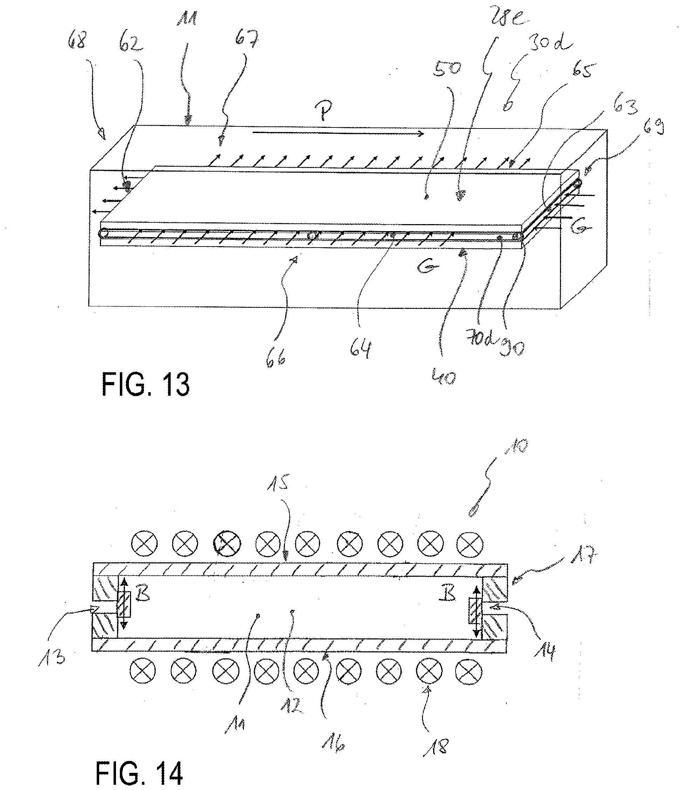

In der nachfolgenden Beschreibung werden für gleiche und gleich wirkende Teile dieselben Bezugsziffern verwendet. In Fig. 1 ist eine Anordnung zweier Gegenstände gezeigt, wie sie mit einer erfindungsgemäßen Vorrichtung herstellbar ist. Die Gegenstände sind als Mehrschichtkörper, hier als Substrate 40, 50 ausgebildet, die zum Prozessieren, insbesondere zum Selenisieren, vorgesehen sind. Die Substrate weisen an einer Oberfläche 44, 54 eine Beschichtung (Precursor) 45, 55 auf (zu prozessierende Oberflächen). Die Beschichtung (Schichtpaket bestehend z. B. aus Kupfer, Indium und Gallium sowie einer abschließenden Bedeckung aus elementarem Selen, Precursor) soll in einer Prozesskammer mit relativ hohen Aufheizraten von bis zu einigen K/s auf höhere Temperaturen gebracht werden, so dass die zuvor aufgetragenen Einzelkomponenten zur Halbleiterverbindung reagieren (schnelle thermische Prozessierung, Rapid Thermal Processing, RTP, von Schichtstapel-Vorläuferschichten, SEL-Precursor, Stacked Elemental Layer). So lassen sich Dünnschichthalbleiter herstellen, beispielsweise Dünnschichtsolarzellen bzw. -module. Solarstromanlagen werden z. B. mit Solarmodulen auf der Basis von Chalkopyrit-Halbleitern (z. B. CuInSe₂, abgekürzt "CIS" oder Cu(In,Ga)(S,Se)₂, abgekürzt "CIGSSE") betrieben. Mit Fig. 1 ist der prinzipielle Aufbau der erfindungsgemäßen Anordnung mit zwei zu prozessierenden Mehrschichtkörpern bzw. Substraten 40, 50 gezeigt, wie sie in eine Anlage zum Prozessieren integrierbar ist. Fig. 14 zeigt eine derartige Anlage in einer Seitenansicht 10. Die Anlage 10 ist ausgelegt, großflächige Substrate zu prozessieren. Zu erkennen ist (s. Fig. 14), dass die Anlage eine Prozesskammer 11 mit einem Kammerdeckel 15, einem Kammerboden 16, Kammerwänden 17 (und damit mit einem Kammerraum 12), eine Eingangstür 13 und eine der Eingangstür gegenüberliegende Ausgangstür 14 aufweist. Die Prozesskammer 11 oder Behandlungskammer weist hier z.B. einen Tunnel auf bzw. bildet einen Tunnel aus, der beispielsweise mit den Türen (Schleusen) abdichtbar ist. Die Pfeile B deuten die Bewegungsrichtung der Eingangstür bzw. der Ausgangstür an. Zum Transport der mindestens beiden Mehrschichtkörper bzw. der Mehrschichtkörperanordnung (hier nicht gezeigt) ist eine Transportvorrichtung (nicht gezeigt) vorgesehen, die die Substrate durch die Türen bzw. Schleusen 13, 14 durch die Prozesskammer 11 transportieren kann. Auch das manuelle Einbringen ist möglich. Ober- und unterhalb der Prozesskammer 11 sind mehrere punktförmige Quellen 18 für elektromagnetische Strahlung z. B. matrixartig angeordnet. Auch eine andere Art von Quellen und/oder einen andere Anordnung dieser Quellen ist möglich. Zum Durchlass der Strahlung sind der Kammerdeckel 15 und der Kammerboden 16 der Prozesskammer 11 zumindest bereichsweise zumindest teiltransparent ausgebildet, um eine homogene Energieeinwirkung auf die Substrate zu ermöglichen. Die Energiequellen können auch innerhalb der Kammer 11 angeordnet sein, dann kann die Wandung der Prozesskammer auch nicht-transparent ausgebildet sein. Auch ist es möglich, die Energiequellen in den entsprechenden Wänden oder Wandabschnitten der Kammer anzuordnen und/oder die Wände derart auszubilden, dass diese unter Einwirkung von Energiequellen als Sekundärstrahler dienen.

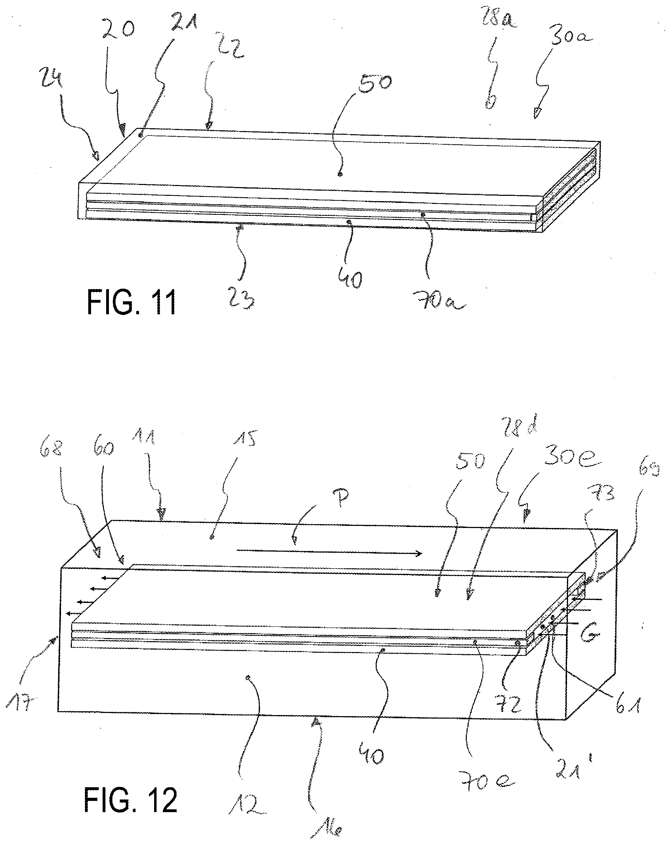

Zurück zur erfindungsgemäßen Vorrichtung bzw. Anordnung. Die Mehrschichtkörper 40, 50 sind derart zueinander angeordnet, dass sich die beschichteten und zu prozessierenden Oberflächen 44, 54 gegenüberliegen (Head-to-Head- bzw. Face-to-Face-Anordnung, Head-to-Head-RTP). Die Substrate 40, 50 liegen dabei im Gebrauch horizontal und sind sandwichförmig übereinander angeordnet. Insofern kann von einem unteren Mehrschichtkörper 40 bzw. einem unteren Substrat und einem oberen Mehrschichtkörper 50 bzw. einem oberen Substrat gesprochen werden. Es ist anzumerken, dass die Mehrschichtkörperanordnung hier "frei schwebend" gezeichnet ist. Dies soll lediglich den Prinzipaufbau der mindestens zwei Substrate aufzeigen, so wie sie in der Anlage prozessiert werden. Deren Lagerungsmöglichkeiten werden nachfolgend detailliert beschrieben. Mit einer derartigen Anordnung der Substrate 40, 50 lässt sich ein definierter Raum zwischen den zu prozessierenden Oberflächen 44, 45 ausbilden. Zudem werden die beiden Substrate 40, 50 gleichzeitig prozessiert, also z. B. selenisiert, so dass sich der Durchsatz durch die Anlage (z. B. wie mit Fig. 14 gezeigt) deutlich erhöht. Der definierte Raum zwischen den Substraten, der sogenannte Prozessraum 21', kann so z. B. gezielt mit einer bestimmten Menge eines Prozessgases für die Durchführung der Prozessierung befüllt werden. Das heißt, in dem Prozessraum 21' erfolgt letztendlich im Wesentlichen die Prozessierung. In der oben beschriebenen Anlage 10 ist es oftmals erwünscht, den Kammerraum 12 der Prozesskammer 11 zu verringern, um die Prozessgaszufuhr bzw. auch -abfuhr und auch die Prozessgasmenge besser kontrollieren zu können. In einem definierten Raum ist auch die Prozessierung, also z.B. die Umwandlung der beschichteten Substratoberflächen besser kalkulier- und nachvollziehbar. Insofern ist der definierte Prozessraum zweckmäßig. Oftmals ist in bekannten Kammerräumen einer Prozesskammer eine Einrichtung zur Ausbildung eines reduzierten Kammerraums (und damit zur Ausbildung des bereits beschriebenen Prozessraums) anordenbar oder angeordnet. Solche Einrichtungen sind z. B. als sogenannte Prozessboxen innerhalb der Prozesskammer vorgesehen, in welche die zu prozessierenden Substrate aufgenommen werden. Auch sind Prozesshauben bekannt, die über die zu prozessierenden Substrate gestülpt (auf die Substrate abgesenkt) werden und auf dem unteren Substrat, auf dem Kammerboden oder einer expliziten Auflage aufliegen. Mit der erfindungsgemäßen Vorrichtung bzw. Anordnung ist es nun möglich, bereits einen definierten Prozessraum 21' vorzusehen, da sich die Substrate 40, 50 gegenüberliegen. Dennoch können zusätzlich, je nach Anforderung an die Prozessierung, explizite Prozessboxen 20, -hauben oder dergleichen Einrichtungen zum Ausbilden eines reduzierten Kammerraums eingesetzt werden (s. z. B. Fig. 11). Sind keine Einrichtungen 20 zum Ausbilden eines reduzierten Kammerraums vorgesehen, bilden auch die Substrate 40, 50 mindestens teilweise diese Einrichtung, also z. B. die Prozessbox, aus. Der Pfeil P deutet die Richtung der Prozessführung an, d. h., die Richtung, in der die Mehrschichtkörperanordnung in der Anlage zum Prozessieren geführt wird.

Fig. 2 zeigt eine Ausführungsform einer Vorrichtung 30a zum Positionieren bzw. eine Mehrschichtkörperanordnung 28a. Um die Substrate 40, 50 (gemäß Fig. 1) zu positionieren, zu der Mehrschichtkörperanordnung zusammenzufügen und in der entsprechenden Anlage zu prozessieren, umfasst die Vorrichtung 30a zum Positionieren hier mindestens ein (erstes) Beabstandungselement oder auch Auflageelement 70a. Das Beabstandungselement 70a ist zwischen den Substraten 40, 50 angeordnet und beabstandet diese voneinander. Hierbei liegt das obere Substrat 50 auf dem Beabstandungselement 70a auf, während das untere Substrat 40 an dem Beabstandungselement 70a anliegt. Die so positionierten Substrate bilden die Mehrschichtkörperanordnung 28a aus.

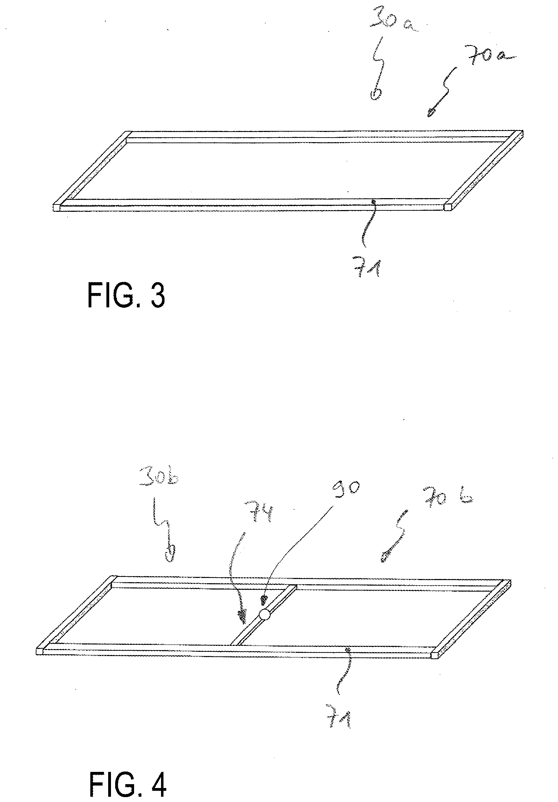

Fig. 3 zeigt das Beabstandungselement 70a alleine. Wie erkennbar, weist das Beabstandungselement 70a ein Rahmenelement 71 auf (bzw. ist als solches ausgebildet). In diesem Falle bildet der Rahmen 71 die Konturen der Substrate (nicht gezeigt) nach (hier rechteckförmig), so dass diese auf dem Rahmenelement 71 mit ihren Kanten bzw. Kantenbereichen 41, 51 aufliegen bzw. an diesem anliegen. Zur Lagerung des unteren Substrats 40 sind weitere Maßnahmen zu treffen, die nachfolgend noch beschrieben werden.

Fig. 4 zeigt eine weitere Ausgestaltung einer Vorrichtung 30b zum Positionieren, hier eines Beabstandungselements 70b. Das Beabstandungselement 70b, hier wieder ein Rahmenelement 71, weist ein Querverbindungselement 74 zum Verbinden von gegenüberliegenden Bereichen des Rahmenelements 71 auf. Damit lässt sich ein Durchbiegen eines aufliegenden Substrats vermeiden. Um nun aber die zu prozessierenden Oberflächen 44, 54 nicht zu sehr abzudecken, weist das Querverbindungselement 74 mindestens ein Abstützelement 90 auf, auf das oder an das das Substrat bzw. die Substrate (nicht gezeigt) auflegbar oder anlegbar ist bzw. sind. In diesem Falle ist das Abstützelement 90 derart ausgebildet, dass es dieselbe Höhe aufweist, wie das übrige Rahmenelement 71. Nur so ist eine ebene Auflagefläche für die Substrate 40, 50 gewährleistet. Sowohl das Rahmenelement 71, als auch das Querverbindungselement 74 können ein oder auch mehrere Abstützelemente aufweisen. Die Auflagebereiche reduzieren sich dadurch, so dass die Substrate an den zu prozessierenden Oberflächen 44, 54 möglichst frei liegen. Die Anzahl der Querverbindungselemente und der Abstützelemente ist beliebig und je nach Bedarf variierbar. Auch die Anordnung der Abstützelemente ist variierbar, d. h. die Abstützelemente können an den Rahmenelementen und/oder an den Querverbindungselementen angeordnet sein. Die Abstützelemente 90 sind vorzugsweise, so wie in Fig. 4 erkennbar, als Punktstützenelemente ausgebildet, also z. B. kugelförmig. Mit den Kugelelementen sind nur kleine Auflagebereiche vorgesehen. Auch nadelförmig ausgebildete Abstützelemente sind denkbar.

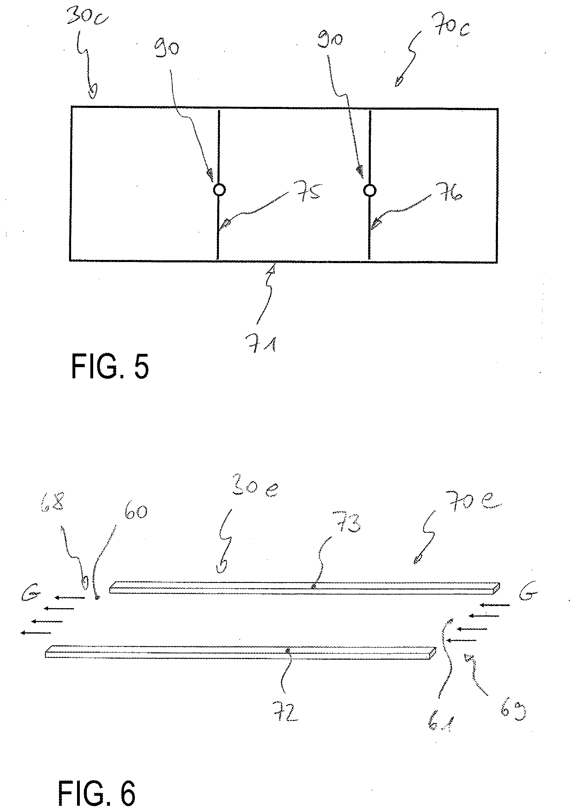

Fig. 5 zeigt eine weitere Ausgestaltung einer Vorrichtung 30c zum Positionieren, hier eines Beabstandungselements 70c (Rahmenelement 71), hier mit zwei Querverbindungselementen 75, 76, an denen jeweils ein Punktstützenelement 90 angeordnet ist.

Auch Fig. 6 zeigt eine weitere Ausgestaltung einer Vorrichtung 30e zum Positionieren, hier eines Beabstandungselements 70e. Das Beabstandungselement 70e weist in einer Erstreckungsebene der Substrate (nicht gezeigt) sich im Gebrauch gegenüberliegende Rahmenleistenelemente 72, 73 auf, so dass die Substrate an deren Kantenbereichen, z.B. an deren Längsseiten, mindestens teilweise auf die Rahmenleistenelemente 72, 73 auflegbar oder an die Rahmenleistenelemente anlegbar sind. An den Querseiten 68, 69 wird aufgrund der Ausgestaltung der Rahmenleistenelemente jeweils mindestens ein Öffnungsbereich 60, 61 an der Mehrschichtkörperanordnung (hier angedeutet) vorgesehen (s. z. B. Fig. 12). Möglich ist es natürlich auch, die Öffnungsbereiche an den Längsseiten vorzusehen. Die Pfeile G deuten die Strömungsrichtung des Prozessgases an. Hierzu wird nachfolgend noch Näheres beschrieben.

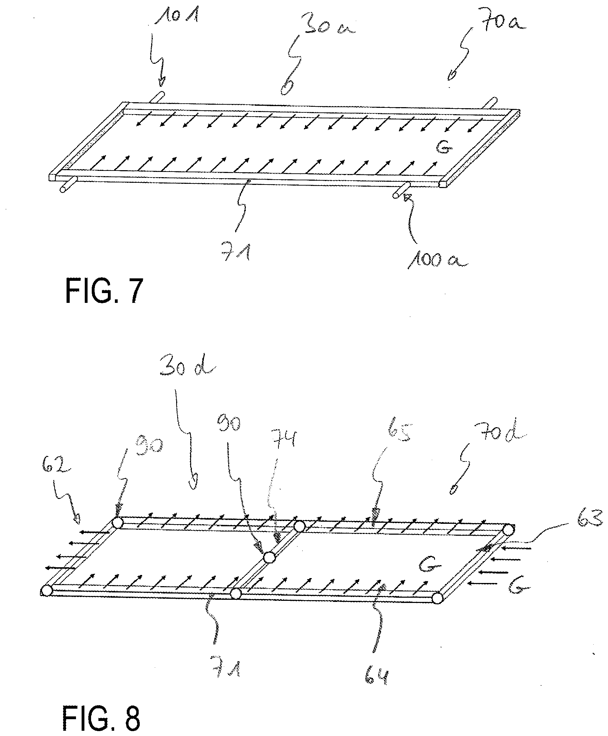

Fig. 7 zeigt schließlich nochmals das Beabstandungselement 70a (s. Fig. 3), allerdings sind hier Vorrichtungen (bzw. eine Vorrichtung) 100a zum Zu- und/oder Abführen von Prozessgas vorgesehen. Auch hier deuten die Pfeile G eine mögliche Strömungsrichtung des Prozessgases an. Wie bereits oben beschrieben, wird die Prozessierung der beschichteten Substratfläche bzw. der Substratbeschichtung unter Prozessgasatmosphäre durchgeführt, um so z. B. den gewünschten Chalkopyrit-Halbleiter zu erhalten. Als Prozessgase können z. B. H₂, N₂, Ar, H₂S, H₂Se, S-Gas und/oder Se-Gas vorgesehen werden, d. h. also ggf. - je nach Prozessart - auch gasförmiges Selen und/oder gasförmiger Schwefel. Grundsätzlich wäre eine Prozessierung auch ohne Prozessgas möglich, beispielsweise in einer vollständig geschlossenen Prozessbox. In diesem Falle könnten die Substrate auch direkt aufeinander liegen und so einen minimierten Prozessraum ausbilden. Das Prozessgas muss derart in den Kammerraum und insbesondere in den Prozessraum zugeführt bzw. auch wieder aus diesem abgeführt werden, dass optimale Prozessierungsbedingungen herrschen. Da gerade mit der vorliegenden Vorrichtung (zwei Substrate, deren Precursor-Schichten gegenüberliegend angeordent sind) bereits ein bestimmter Prozessraum ausgebildet wird, kann das Prozessgas beispielsweise über das Beabstandungselement zugeführt werden (von einer Gasquelle), ggf. sogar unter Umgehung des Kammerraums und/oder des Prozessraums einer expliziten Prozessbox. Das Beabstandungselement 70a gemäß Fig. 7 weist also ein Gaszufuhrelement und/oder ein Gasabfuhrelement 100a zum Zuführen und/oder Abführen des Prozessgases in den und/oder aus dem Prozessraum auf. Bei dieser Art Beabstandungselement 70a wird ein quasi-geschlossener Prozessraum gebildet, da das Rahmenelement den Raum zwischen den Precursor-Schichten im Wesentlichen vollständig abschließt. Eine fluiddurchlässige, insbesondere gasdurchlässige Verbindung zwischen dem Kammerraum der Anlage und dem Prozessraum oder auch nur zwischen der Gasquelle und dem Prozessraum zwischen den beiden Substraten wird so über die Gaszufuhrelemente und/oder ein Gasabfuhrelemente gewährleistet. Das Gaszufuhrelement bzw. Gasabfuhrelement 100a kann beispielsweise als ein in das Beabstandungselement integrierter Gasverteiler-Kamm mit mindestens einem Anschlusselement 101 zum Anschließen einer Gaszuführleitung und/oder Gasabführleitung (nicht gezeigt) ausgebildet sein. Der gezeigte Rahmen 70a weist z. B. vier Anschlusselemente 101 auf (zum Anschluss von Gasleitungen), so dass das Gas über das hohle Rahmenelement und entsprechende Öffnungen (nicht sichtbar) für den Gasauslass (oder -einlass) in den Prozessraum, also zwischen die Substrate eindringen kann (partieller bzw. anpassbarer Gasaustausch zwischen Ofenumgebung (Umgebung in der Kammer oder im Tunnel oder auch Umgebung in einer expliziten Prozessbox oder Prozesshaube) und Precursor-Dünnschichten oder direkt zwischen Gasquelle und Precursor-Dünnschichten). An sich können die Gasverteiler 100a auch anderweitig an der Kammer angeordnet werden. Wichtig ist es, ein homogenes Einleiten des Prozessgases zu ermöglichen, so dass es zu einer möglichst laminaren Gasströmung über die Substratoberfläche von z. B. einer Längskante zur anderen kommt. Die Gaszufuhr kann an vorgegebenen Einlässen der Gasverteiler zu beliebigen Zeiten des Temperprofiles gesteuert werden. Verbrauchte Mengen des Prozessgases können so nachgeladen werden und/oder nicht mehr erwünschter überschüssiger Selendampf (oder sonstige Komponenten des Dampfes) kann aus der Reaktionskammer zum richtigen Zeitpunkt verdrängt werden.

Fig. 8 zeigt eine weitere Ausgestaltung einer Vorrichtung 30d zum Positionieren, hier eines Beabstandungselements 70d. Dieses umfasst ein Rahmenelement 71 mit einem Querverbindungselement 74 und mehreren Abstützelementen 90 (jeweils ein Abstützelement an den Ecken des Rahmenelements und an den Schnittpunkten von Rahmenelement und Querverbindungselement sowie ein Abstützelement an dem Querverbindungselement). Die Abstützelemente 90 sind hier wiederum als Kugelelemente ausgebildet. In diesem Falle sind die Kugelelemente 90 in ihrem Durchmesser größer als die Höhe des Rahmenelements 71 ausgebildet. Insofern sind die auf- oder anliegenden Substrate (nicht gezeigt) nur auf den Kugelelementen 90 lagerbar, so dass Öffnungsbereiche 62, 63, 64, 65 an der Mehrschichtkörperanordnung (hier angedeutet) zum Gasaustausch zwischen dem Rahmenelement 71 und den Substraten verbleiben. Auch auf diese Art lässt sich ein quasi-offener Prozessraum, d. h., eine quasi-offene Sandwich-Vorrrichtung ausbilden. Zur besseren Übersicht sind nur zwei der Kugelelemente mit dem Bezugszeichen 90 versehen.

Nachfolgend werden weitere verschiedene Ausführungsformen der Vorrichtung bzw. Anordnung (Mehrschichtkörperanordnung) dargestellt, die einige der soeben beschriebenen Beabstandungselemente zeigen.

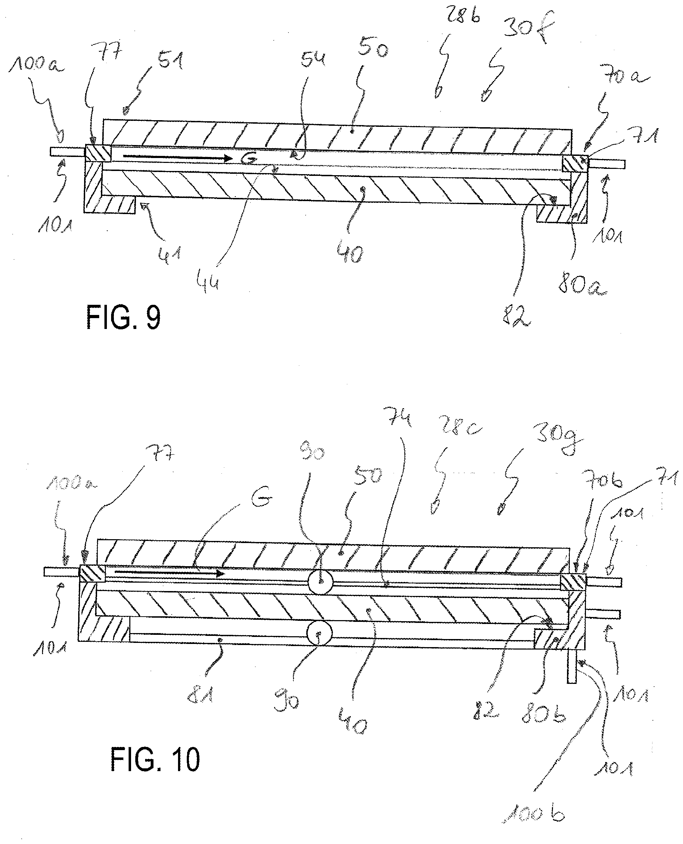

Fig. 9 zeigt eine weitere Ausgestaltung einer Vorrichtung 30f zum Positionieren bzw. einer erfindungsgemäßen Mehrschichtkörperanordnung 28b in einer Schnittdarstellung. Das erste Beabstandungselement 70a (s. z.B. Fig. 3 oder 7) umfasst hier zusätzlich eine Vorrichtung 100a zum Zu- und Abführen von Prozessgas, da der Rahmen 71 selbst den Prozessraum abschließt. Ferner ist ein zweites Beabstandungselement 80a vorgesehen. Das zweite Beabstandungselement 80a ist hier zur Aufnahme des unteren Mehrschichtkörpers 40 vorgesehen und ist mindestens teilweise unter dem unteren Mehrschichtkörper 40 anordenbar bzw. angeordnet. Außerdem ist es zur Aufnahme des ersten Beabstandungselements 70a ausgebildet, so dass das zweite Beabstandungselement 80a, der untere Mehrschichtkörper 40, das erste Beabstandungselement 70a und der obere Mehrschichtkörper 50 sandwichförmig als Mehrschichtkörperanordnung 28b anordenbar sind bzw. hier angeordnet sind. Beide Beabstandungselemente 70a, 80a weisen Auflagebereiche 77, 82 auf, über welche die Substrate 40, 50 auf- oder anlegbar sind. Das zweite Beabstandungselement 80a kann selbst als Rahmenelement ausgebildet sein oder beispielsweise auch zwei Rahmenleistenelemente vorsehen. Die mit den Figuren 2 bis 8 gezeigten Ausgestaltungen der Beabstandungselemente können ebenfalls für das zweite Beabstandungselement vorgesehen sein. Wie aus der Figur ersichtlich, könnte das zweite, also untere Beabstandungselement 80a auch derart ausgebildet sein, dass es mit dem unteren Auflagebereich 82 das untere Substrat 40 aufnimmt und in einem oberen Auflagebereich das obere Substrat 50. Gegebenenfalls müsste das untere Substrat dann auf den unteren Auflagebereich seitlich eingeschoben werden. Eine Lagerung mit dem zweiten Beabstandungselement alleine ist also ebenfalls möglich.

In dem in Fig. 9 gezeigten Ausführungsbeispiel ist das erste Beabstandungselement 70a auf das zweite Beabstandungselement 80a aufgesetzt, so dass letztendlich mit den Substraten 40, 50 die sandwichförmige Anordnung ausgebildet wird. Die Gaszufuhr- und/oder -abfuhrelemente können nur an einem oder auch an beiden Beabstandungselementen vorgesehen sein. Der Pfeil G deutet die Richtung der Gasströmung an.

Fig. 10 zeigt im Wesentlichen die bereits mit Fig. 9 beschriebene Ausführungsform der Vorrichtung bzw. Anordnung. Allerdings sind die Beabstandungselemente (Rahmenelemente) mit den Querverbindungselementen ausgebildet und zudem mit Punktstützenelementen, die hier nur an den Querverbindungselementen vorgesehen sind. Das heißt, es ist eine Vorrichtung 30g zum Positionieren gezeigt bzw. eine Mehrschichtkörperanordnung 28c Das erste Beabstandungselement 70b (Rahmenelement 71 mit Querverbindungselement 74) ist z. B. dasjenige aus Fig. 4, jedoch mit einer Vorrichtung 100a zum Zu- und/oder Abführen von Prozessgas. Ein zweites Beabstandungselement 80b entspricht im Wesentlichen demjenigen in Fig. 9, allerdings mit einer weiteren Vorrichtung 100b zum Zu- und/oder Abführen von Prozessgas. Das Beabstandungselement 70b weist z.B. das Querverbindungselement 74 auf, das Beabstandungselement 80b ein Querverbindungselement 81. Mittig an den Querverbindungselementen ist jeweils ein Abstützelement 90 angeordnet. Die Substrate liegen so jeweils auf den Auflageflächen bzw. Auflagebereichen 77 bzw. 82 und den jeweiligen Abstützelementen 90 auf. Auch hier deutet der Pfeil G die Richtung der Gasströmung an.

Fig. 11 zeigt die erfindungsgemäße Vorrichtung 30a bzw. Anordnung 28a, wie sie z. B. mit Fig. 2 beschrieben ist. Auch diese Darstellung ist eine prinzipielle, da die Möglichkeit des Gasaustausches mit der Umgebung nicht explizit dargestellt ist (Austausch z. B. zwischen Prozessraum zwischen den Substraten und Prozessraum der Box sowie zwischen Box und Kammerraum oder auch lediglich zwischen Gasquelle und Prozessraum zwischen den Substraten). Mit dieser Abbildung soll die Anordnung der erfindungsgemäßen Anordnung 28a bzw. Vorrichtung 30a in einer Einrichtung 20 zur Ausbildung eines reduzierten Kammerraumes, hier einer Prozessbox, aufgezeigt werden. Die Einrichtung 20 ist dann zusammen mit der Mehrschichtkörperanordnung 28a in die Anlage 10 (s. Fig. 14) zum Prozessieren einbringbar, so dass die gewünschten Prozesse durchgeführt werden können. Grundsätzlich ist auch an eine Prozessierung ohne jeglichen Gasaustausch (z. B. zwischen Prozesskammer und Prozessbox bzw. zwischen einer Gasquelle und der Prozesskammer bzw. Prozessbox oder -haube) zu denken. Fluid- insbesondere Gasaustausch zwischen den Ebenen der Prozessieranlage ist auf unterschiedliche Weise möglich. So kann z. B. der Austausch von Gas zwischen einer (z. B. externen) Gasquelle, der Prozesskammer (oder dem Prozesstunnel) und ggf. der Prozessbox oder -haube erfolgen. Auch kann der Gasaustausch zwischen externer Gasquelle und einer ggf. vorhandenen Prozessbox oder -haube unter Umgehung der Prozesskammer erfolgen, d. h., die Prozessbox steht mit der Gasquelle unmittelbar in Verbindung. Möglich ist es auch, den Gasaustausch lediglich zwischen der durch die Substrate ausgebildeten Prozessbox und der Gasquelle zu gewährleisten. Die beiden Substrate 40, 50 sind mit dem dazwischen angeordneten Beabstandungselement 70a in der Prozessbox 20 gelagert. Die Prozessbox 20 umfasst ein Bodenelement 23, ein Deckelelement 22 und Seitenwandelemente 24 und umschließt so die Anordnung. Somit sind neben dem Kammerraum 12 der Prozesskammer (nicht gezeigt) ein expliziter Prozessraum 21 vorgesehen und die Prozessierung läuft in einem definierten Raumvolumen ab. Dies erleichtert die Zuführung einer definierten Prozessgasmenge. Das untere Substrat 40 liegt auf dem Bodenelement 23 der Prozessbox 20 auf, so dass auf ein zweites Beabstandungselement (einem unteren Beabstandungselement) verzichtet werden kann. An dieser Anordnung lassen sich nun, wie gewünscht, entsprechende Gaszufuhr- und/oder -abfuhrelemente (nicht gezeigt, aber wie z. B. oben beschrieben) anbringen.

Fig. 12 zeigt die Vorrichtung 30e von Fig. 6 bzw. eine Anordnung 28d der zwei Mehrschichtkörper 40, 50 mit dem dazwischen angeordneten Beabstandungselement 70e im Kammerraum 12 einer Prozesskammer 11 oder in einem Tunnel einer Anlage. Hier ist keine explizite Prozessbox vorgesehen, vielmehr wird ein Prozessraum 21' durch die Anordnung selbst ausgebildet. Das heißt, die Substrate 40, 50 und auch die Vorrichtung zum Positionieren, hier das Beabstandungselement 70e, bilden mit die Prozessbox aus, so dass der zwischen den Precursor-Schichten bzw. den zu prozessierenden Oberflächen vorgesehene Raum im Wesentlichen als der Prozessraum 21' ausgebildet ist. Das Beabstandungselement 70e entspricht den in Fig. 6 beschriebenen beiden gegenüberliegenden Rahmenleistenelementen, so dass an der Anordnung 28d an den Querseiten 68, 69 jeweils ein Öffnungbereich 60, 61 ausgebildet ist. Über diese Öffnungsbereiche 60, 61 findet der Gasaustausch mit dem Kammerraum bzw. Tunnelraum statt. Somit ist im Prinzip ein quasi-offener Prozessraum 21' mit einem quasi-offenen Beabstandungselement 70e ausgebildet. Die Prozessführung ist wie mit dem Pfeil P angedeutet vorgesehen, d. h., die Prozessbox mit der Beladung wird in die mit dem Pfeil angedeutete Richtung in die Gesamtanlage transportiert. Üblicherweise sind hierfür die Schleusen 13, 14 an der Prozesskammer 11 vorgesehen, so dass im Kammerraum 12 ein entsprechender Prozessgasdruck einstellbar ist. Die entgegengesetzt gerichteten kurzen Pfeile G zeigen auf, wie das Prozessgas durch den Prozessraum (zwischen den beiden Substraten geführt) wird. Mit dem quasi-offenen Beabstandungselement kann auf explizite Gaszufuhrelemente bzw. Gasabfuhrelemente verzichtet werden. Das Gas wird von mindestens einer Gasquelle aus eingeleitet, beispielsweise von der oben bereits erwähnten externen Gasquelle, um Kammerraum 12 und Prozessraum 21' zu befüllen. Die Anordnung 28d ist hier rein schematisch frei schwebend abgebildet. In der Praxis müssten zu deren Lagerung explizite Elemente, wie z. B. ein zweites Beabstandungselement, vorgesehen sein, das selbst auf dem Bodenbereich der Kammer oder des Tunnels aufliegt oder aber die Anordnung liegt auf dem Kammerboden 16 oder auf einem Carrier auf.

Fig. 13 zeigt eine Anordnung 28e bzw. die Vorrichtung 30d (Fig. 8), die ebenfalls in einem Kammerraum oder Tunnelraum 12, wie mit Fig. 12 beschrieben, angeordnet sind. Das Beabstandungselement 70d ist das mit Fig. 8 beschriebene. Da die Substrate 40, 50 nur auf den Kugelelementen aufliegen bzw. an diesen anliegen, ist die Anordnung eine quasi-offene, das Prozessgas kann, wie mit den kurzen Pfeilen angedeutet, zwischen der Kammer- bzw. Tunnelumgebung über die Öffnungsbereiche 62, 63 an den Querseiten 68, 69 bzw. über die Öffnungsbereiche 64, 65 an den Längsseiten 66, 67 der Anordnung 28d ausgetauscht werden.

Fig. 14 zeigt schließlich die bereits oben beschriebene Anlage 10, in die die Anordnungen 28a, 28b, 28c, 28d und/oder 28e mit den Vorrichtungen 30a, 30b, 30c, 30d, 30e, 30f und/oder 30g zum Positionieren (hier nicht eingezeichnet) zum Prozessieren mit oder ohne explizite Einrichtung zum Ausbilden eines reduzierten Kammerraums eingebracht werden können. Der Transport der Anordnung bzw. der Vorrichtung (mit oder ohne Einrichtung zum Ausbilden eines reduzierten Kammerraums) in die Anlage und aus dieser heraus erfolgt beispielsweise über eine Transportvorrichtung (nicht gezeigt), die mit oder ohne Träger (also z. B. Carrier) für die Substrate arbeitet oder auch manuell. Auch der Zusammenbau der Mehrschichtkörperanordnung in der Anlage ist möglich.

Die Mehrschichtkörperanordnung könnte ebenfalls auf einem Carrier aufgebaut werden und so in die Prozesskammer oder in einen Prozesstunnel der Prozessieranlage (z. B. mittels einer Transportvorrichtung) eingebracht werden (in der sich z.B. eine Prozesshaube befindet, die auf die Mehrschichtkörperanordnung absenkbar ist). Auch ohne eine explizite Einrichtung zur Ausbildung eines reduzierten Kammerraums ließe sich die Prozessierung durchführen.

Mit der vorgestellten Vorrichtung zum Positionieren von Gegenständen, mit einer damit ausgebildeten Mehrschichtkörperanordnung, mit einer Mehrschichtkörperanordnung, die ohne Vorrichtung zum Positionieren zusammengebaut ist, einer Anlage zum Prozessieren der Mehrschichtkörperanordnung und mit den entsprechenden Verfahren zum Ausbilden der Mehrschichtkörperanordnung lassen sich Mehrschichtkörper, z. B. Substrate, auf einfache Weise mit hohem Durchsatz prozessieren (beispielsweise zur Herstellung von Chalkopyrit-Halbleitern).

Im Folgenden werden weitere Aspekte der Erfindung beschrieben:
Die Erfindung zeigt eine Vorrichtung zum Positionieren von mindestens zwei Gegenständen, insbesondere von mindestens zwei Mehrschichtkörpern mit jeweils mindestens einer zu prozessierenden Oberfläche, wobei die Vorrichtung zur Aufnahme der mindestens zwei Gegenstände, insbesondere Mehrschichtkörper, derart ausgebildet ist, dass sich die jeweils zu prozessierenden Oberflächen gegenüberliegen und die Gegenstände, insbesondere Mehrschichtkörper, so einen zwischen den Oberflächen angeordneten Prozessraum ausbilden, in dem im Wesentlichen die Prozessierung erfolgt, so dass die mindestens zwei Gegenstände als eine Mehrschichtkörperanordnung in einer Prozessieranlage prozessierbar, insbesondere selenisierbar sind. In einer Ausführungsform ist die Vorrichtung derart ausgebildet, dass sie in einer Prozesskammer oder einem Prozesstunnel der Prozessieranlage mit einem Kammerraum und/oder in einer Einrichtung zum Ausbilden eines reduzierten Kammerraums, vorzugsweise in einer Prozessbox mit einem Bodenelement, einem Deckelelement und vorzugsweise mit Seitenwandelementen oder innerhalb einer Prozesshaube, die insbesondere zum stationären Verbleib in der Prozessieranlage ausgebildet ist, und/oder auf oder an einem Tragelement zum Transportieren der Mehrschichtkörperanordnung mittels einer Transportvorrichtung in die Prozessieranlage und aus dieser heraus, anordenbar oder angeordnet ist. In einer Ausführungsform ist die Vorrichtung derart ausgebildet, dass die Mehrschichtkörper im Gebrauch sandwichförmig übereinanderliegend angeordnet sind und so einen unteren Mehrschichtkörper und einen oberen Mehrschichtkörper der Mehrschichtkörperanordnung ausbilden. In einer Ausführungsform ist die Vorrichtung derart ausgebildet und/oder in einem Kammerraum einer Prozesskammer der Prozessieranlage anordenbar, dass die zwei Mehrschichtkörper derart anordenbar sind, dass sie mindestens teilweise die Einrichtung zum Ausbilden eines reduzierten Kammerraums, vorzugsweise eine Prozessbox, ausbilden. In einer Ausführungsform weist die Vorrichtung mindestens ein erstes Beabstandungselement auf, das zur Aufnahme des oberen Mehrschichtkörpers und/oder des unteren Mehrschichtkörpers ausgebildet ist, wobei das Beabstandungselement derart mindestens teilweise zwischen den zwei Mehrschichtkörpern anordenbar ist, dass diese beabstandet voneinander anordenbar oder angeordnet sind und so die Mehrschichtkörperanordnung ausbilden. In einer Ausführungsform weist die Vorrichtung mindestens ein zweites Beabstandungselement auf, das zur Aufnahme des oberen Mehrschichtkörpers und/oder des unteren Mehrschichtkörpers und zur Aufnahme des ersten Beabstandungselements ausgebildet ist, derart, dass das zweite Beabstandungselement, der untere Mehrschichtkörper, das erste Beabstandungselement und der obere Mehrschichtkörper sandwichförmig anordenbar oder angeordnet sind und so die Mehrschichtkörperanordnung ausbilden, wobei vorzugsweise das zweite Beabstandungselement im Gebrauch mindestens teilweise unter dem unteren Mehrschichtkörper anordenbar oder angeordnet ist. In einer Ausführungsform weisen in der Vorrichtung das erste Beabstandungselement und/oder das zweite Beabstandungselement jeweils mindestens ein Rahmenelement und/oder ein Rahmenleistenelement auf, so dass die Mehrschichtkörper vorzugsweise an deren Kantenbereichen mindestens teilweise auf das Rahmenelement und/oder das Rahmenleistenelement auflegbar oder an das Rahmenelement und/oder das Rahmenleistenelement anlegbar sind. In einer Ausführungsform sind in der Vorrichtung die zwei Mehrschichtkörper und das erste Babstandungselement oder die zwei Mehrschichtkörper und das erste Beabstandungselement und das zweite Beabstandungselement derart zueinander angeordnet, dass sie einen im Wesentlichen geschlossenen Prozessraum ausbilden. In einer Ausführungsform weisen in der Vorrichtung das erste Beabstandungselement und/oder das zweite Beabstandungselement zwei Rahmenleistenelemente auf, die sich im Gebrauch in einer Erstreckungsebene der Mehrschichtkörper gegenüberliegen, so dass die Mehrschichtkörper vorzugsweise an deren Kantenbereichen, vorzugsweise an deren Längsseiten, mindestens teilweise auf die Rahmenleistenelemente auflegbar oder an die Rahmenleistenelemente anlegbar sind, derart, dass an der Mehrschichtkörperanordnung, vorzugsweise jeweils an den Querseiten, mindestens ein Öffnungsbereich zum Zuführen und/oder Abführen eines Prozessgases in den und/oder aus dem Prozessraum ausgebildet ist. In einer Ausführungsform weisen in der Vorrichtung das erste Beabstandungselement und/oder das zweite Beabstandungselement ein Gaszufuhrelement und/oder Gasabfuhrelement zum Zuführen und/oder Abführen des Prozessgases in den und/oder aus dem Prozessraum auf, wobei vorzugsweise das Gaszufuhrelement und/oder Gasabfuhrelement als ein in das erste Beabstandungselement und/oder das zweite Beabstandungselement integrierter Gasverteiler-Kamm mit mindestens einem Anschlusselement zum Anschließen einer Gaszuführleitung und/oder Gasabführleitung ausgebildet ist. In einer Ausführungsform weisen in der Vorrichtung das erste Beabstandungselement und/oder das zweite Beabstandungselement jeweils mindestens ein Querverbindungselement zum Verbinden von, in der Erstreckungsebene der Mehrschichtkörper sich gegenüberliegenden Bereichen des jeweiligen Rahmenelements oder von sich im Gebrauch gegenüberliegenden Rahmenleistenelementen auf, so dass der oder die Mehrschichtkörper zur Vermeidung einer Durchbiegung zusätzlich abstützbar ist oder sind. In einer Ausführungsform weist in der Vorrichtung das Querverbindungselement mindestens ein Abstützelement auf, vorzugsweise ein Punktstützenelement, insbesondere vorzugsweise ein Kugelelement, so dass die Mehrschichtkörper auf dem oder an dem Querverbindungselement über das Abstützelement auflegbar oder anlegbar sind, wobei das Abstützelement derart ausgebildet ist, dass es dieselbe Höhe wie das jeweilige mindestens eine Rahmenelement oder Rahmenleistenelement aufweist. In einer Ausführungsform weist in der Vorrichtung das mindestens eine Rahmenelement oder Rahmenleistenelement mindestens zwei Abstützelemente derart auf, dass die Mehrschichtkörper auf den oder an den Abstützelementen auflegbar oder anlegbar sind, derart, dass an den Querseiten und/oder Längsseiten der Mehrschichtkörperanordnung jeweils mindestens ein Öffnungsbereich zum Zuführen und/oder Abführen des Prozessgases in den und/oder aus dem Prozessraum ausgebildet ist. Erfindungsgemäß umfasst eine Mehrschichtkörperanordnung mindestens zwei Mehrschichtkörper mit jeweils mindestens einer zu prozessierenden Oberfläche und mindestens eine wie oben beschriebene Vorrichtung zum Positionieren der mindestens zwei Mehrschichtkörper. Erfindungsgemäß umfasst eine Mehrschichtkörperanordnung mindestens zwei Mehrschichtkörper mit jeweils mindestens einer zu prozessierenden Oberfläche, wobei die mindestens zwei Mehrschichtkörper derart angeordnet sind, dass sich die jeweils zu prozessierenden Oberflächen gegenüberliegen und die Mehrschichtkörper so einen zwischen den Oberflächen angeordneten Prozessraum ausbilden, in dem im Wesentlichen die Prozessierung erfolgt. Erfindungsgemäß umfasst eine Anlage zum Prozessieren, insbesondere zum Selenisieren, von mindestens zwei Gegenständen, insbesondere von mindestens zwei Mehrschichtkörpern mit jeweils mindestens einer zu prozessierenden Oberfläche mindestens eine Prozesskammer mit einem Kammerraum und eine wie oben beschriebene Vorrichtung zum Positionieren der mindestens zwei Gegenstände. Erfindungsgemäß umfasst ein Verfahren zum Positionieren von mindestens zwei Gegenständen, insbesondere von mindestens zwei Mehrschichtkörpern mit jeweils mindestens einer zu prozessierenden Oberfläche mittels einer Vorrichtung zum Positionieren der mindestens zwei Gegenstände, insbesondere Mehrschichtkörper, die zur Aufnahme der mindestens zwei Gegenstände, insbesondere der Mehrschichtkörper, ausgebildet ist, die folgenden Schritte: Anordnen der Vorrichtung an einer dafür vorgesehenen Stelle; Anordnen der zwei Gegenstände, insbesondere der zwei Mehrschichtkörper, an der Vorrichtung derart, dass sich die jeweils zu prozessierenden Oberflächen gegenüberliegen und die Gegenstände, insbesondere Mehrschichtkörper, so einen zwischen den Oberflächen angeordneten Prozessraum ausbilden, in dem im Wesentlichen die Prozessierung erfolgt, so dass die mindestens zwei Gegenstände als eine Mehrschichtkörperanordnung in einer Prozessieranlage prozessierbar, insbesondere selenisierbar sind. Erfindungsgemäß umfasst ein Verfahren zum Positionieren von mindestens zwei Gegenständen, insbesondere von mindestens zwei Mehrschichtkörpern mit jeweils mindestens einer zu prozessierenden Oberfläche die folgenden Schritte: Anordnen der zwei Gegenstände, insbesondere der zwei Mehrschichtkörper derart, dass sich die jeweils zu prozessierenden Oberflächen gegenüberliegen und die Gegenstände, insbesondere Mehrschichtkörper, so einen zwischen den Oberflächen angeordneten Prozessraum ausbilden, in dem im Wesentlichen die Prozessierung erfolgt, so dass die mindestens zwei Gegenstände als eine Mehrschichtkörperanordnung in einer Prozessieranlage prozessierbar, insbesondere selenisierbar sind.

### Bezugszeichenliste

10 Anlage zum Prozessieren
11 Prozesskammer, -tunnel
12 Kammerraum
13 Eingangstür
14 Ausgangstür
15 Kammerdeckel
16 Kammerboden
17 Kammerwand bzw. -wände
18 Quelle(n) für elektromagnetische Strahlung
20 Einrichtung zur Ausbildung eines reduzierten Kammerraums, Prozessbox
21, 21' Prozessraum
22 Deckelelement
23 Bodenelement
24 Seitenwandelement(e)
28a Anordnung, Mehrschichtkörperanordnung
28b Anordnung, Mehrschichtkörperanordnung
28c Anordnung, Mehrschichtkörperanordnung
28d Anordnung, Mehrschichtkörperanordnung
28e Anordnung, Mehrschichtkörperanordnung
30a Vorrichtung zum Positionieren
30b Vorrichtung zum Positionieren
30c Vorrichtung zum Positionieren
30d Vorrichtung zum Positionieren
30e Vorrichtung zum Positionieren
30f Vorrichtung zum Positionieren
30g Vorrichtung zum Positionieren
40 Unterer Mehrschichtkörper, Substrat
41 Kantenbereich(e)
44 Zu prozessierende Oberfläche
45 (Precursor-) Beschichtung
50 Oberer Mehrschichtkörper, Substrat
51 Kantenbereich(e)
54 Zu prozessierende Oberfläche
55 (Precursor-) Beschichtung
60 Öffnungsbereich Anordnung
61 Öffnungsbereich Anordnung
62 Öffnungsbereich Anordnung
63 Öffnungsbereich Anordnung
64 Öffnungsbereich Anordnung
65 Öffnungsbereich Anordnung
66 Längsseite Anordnung
67 Längsseite Anordnung
68 Querseite Anordnung
69 Querseite Anordnung
70a Erstes Beabstandungselement
70b Erstes Beabstandungselement
70c Erstes Beabstandungselement
70d Erstes Beabstandungselement
70e Erstes Beabstandungselement
71 Rahmenelement
72 Rahmenleistenelement
73 Rahmenleistenelement
74 Querverbindungselement
75 Querverbindungselement
76 Querverbindungselement
77 Auflagebereich
80a Zweites Beabstandungselement
80b Zweites Beabstandungselement
81 Querverbindungselement
82 Auflagebereich
90 Abstützelement(e)
100a Vorrichtung zum Zu- und/oder Abführen von Prozessgas, Gaszufuhrelement(e) und/oder Gasabfuhrelement(e)
100b Vorrichtung zum Zu- und/oder Abführen von Prozessgas, Gaszufuhrelement(e) und/oder Gasabfuhrelement(e)
101 Anschlusselement(e)
G Richtung Gasströmung
P Richtung Prozessführung
B Bewegungsrichtung Eingangstür, Ausgangstür

## Patentansprüche

1. Mehrschichtkörperanordnung (28a bis 28e), umfassend
- mindestens zwei Mehrschichtkörper (40, 50) mit jeweils mindestens einer zu prozessierenden Oberfläche (44, 54),
- mindestens eine Vorrichtung (30a bis 30g) zum Positionieren der Mehrschichtkörper (40, 50), wobei die Vorrichtung (30a bis 30g) derart ausgebildet ist, dass sich die jeweils zu prozessierenden Oberflächen (44, 54) gegenüberliegen, **dadurch gekennzeichnet, dass** sie so einen zwischen den Oberflächen (44, 54) angeordneten, quasi-geschlossenen Prozessraum (21') ausbilden, in dem die Prozessierung erfolgt, wobei quasi-geschlossen einen Prozessraum beschreibt, der am Rand offen ist und bei dem für den Zeitraum der Prozessierung der Mehrschichtkörper praktisch kein Gasaustausch zwischen dem Prozessraum und seiner Umgebung stattfindet, so dass keine nennenswerte Veränderung der Prozessbedingungen im Prozessraum stattfindet.

2. Mehrschichtkörperanordnung (28a bis 28e) nach Anspruch 1, welche
- in einer Prozesskammer, oder
- in einem Prozesstunnel (11) einer Prozessieranlage (10) mit einem Kammerraum (12), und/oder
- in einer Einrichtung (20) zum Ausbilden eines reduzierten Kammerraums, beispielsweise in einer Prozessbox (20) oder innerhalb einer Prozesshaube, die insbesondere zum stationären Verbleib in einer Prozessieranlage (10) ausgebildet ist, und/oder
- auf oder an einem Tragelement zum Transportieren mittels einer Transportvorrichtung in eine Prozessieranlage (10) und aus dieser heraus, angeordnet ist.

3. Mehrschichtkörperanordnung (28a bis 28e) nach Anspruch 2, bei welcher die Vorrichtung (30a bis 30g) dazu ausgebildet ist, die zwei Mehrschichtkörper (40, 50) so anzuordnen, dass diese mindestens teilweise die Einrichtung (20) zum Ausbilden eines reduzierten Kammerraums ausbilden.

4. Mehrschichtkörperanordnung (28a bis 28e) nach einem der Ansprüche 1 bis 3, bei welcher die Vorrichtung (30a bis 30g) derart ausgebildet ist, dass die Mehrschichtkörper (40, 50) im Gebrauch sandwichförmig übereinanderliegend angeordnet sind und so einen unteren Mehrschichtkörper (40) und einen oberen Mehrschichtkörper (50) ausbilden.

5. Mehrschichtkörperanordnung (28a bis 28e) nach Anspruch 4, bei welcher die Vorrichtung (30a bis 30g) mindestens ein erstes Beabstandungselement (70a, 70b, 70c, 70d, 70e) aufweist, das zur Aufnahme des oberen Mehrschichtkörpers (50) und/oder des unteren Mehrschichtkörpers (40) ausgebildet ist, wobei das Beabstandungselement (70a bis 70e) derart mindestens teilweise zwischen den zwei Mehrschichtkörpern (40, 50) angeordnet ist, dass diese beabstandet voneinander angeordnet sind.

6. Mehrschichtkörperanordnung (28a bis 28e) nach Anspruch 5, bei welcher die Vorrichtung (30a bis 30g) mindestens ein zweites Beabstandungselement (80a, 80b) aufweist, das zur Aufnahme des oberen Mehrschichtkörpers (50) und/oder des unteren Mehrschichtkörpers (40) und zur Aufnahme des ersten Beabstandungselements (70a bis 70e) ausgebildet ist, derart, dass das zweite Beabstandungselement (80a, 80b), der untere Mehrschichtkörper (40), das erste Beabstandungselement (70a bis 70e) und der obere Mehrschichtkörper (50) sandwichförmig angeordnet sind.

7. Mehrschichtkörperanordnung (28a bis 28e) nach einem der Ansprüche 5 oder 6, bei welcher das erste Beabstandungselement (70a bis 70e) und/oder das zweite Beabstandungselement (80a, 80b) jeweils mindestens ein Rahmenelement (71) und/oder ein Rahmenleistenelement (72, 73) aufweisen, so dass die Mehrschichtkörper (40, 50) insbesondere an deren Kantenbereichen (41, 51) mindestens teilweise dem Rahmenelement und/oder dem Rahmenleistenelement (71, 72, 73) auf- oder anliegen.

8. Mehrschichtkörperanordnung (28a bis 28e) nach einem der Ansprüche 5 bis 7, bei welcher das erste Beabstandungselement und/oder das zweite Beabstandungselement (80a, 80b) zwei Rahmenleistenelemente (72, 73) aufweisen, die sich im Gebrauch in einer Erstreckungsebene der Mehrschichtkörper (40, 50) gegenüberliegen, so dass die Mehrschichtkörper (40, 50) insbesondere an deren Kantenbereichen (41, 51), insbesondere an deren Längsseiten, mindestens teilweise den Rahmenleistenelementen (72, 73) auf- oder anliegen, derart, dass an der Mehrschichtkörperanordnung (28a bis 28e), insbesondere jeweils an den Querseiten (68, 69), mindestens ein Öffnungsbereich (60, 61) zum Zuführen und/oder Abführen eines Prozessgases in den und/oder aus dem Prozessraum (21') ausgebildet ist.

9. Mehrschichtkörperanordnung (28a bis 28e) nach einem der Ansprüche 5 bis 8, bei welcher das erste Beabstandungselement (70a bis 70e) und/oder das zweite Beabstandungselement (80a, 80b) ein Gaszufuhrelement und/oder Gasabfuhrelement (100a, 100b) zum Zuführen und/oder Abführen des Prozessgases in den und/oder aus dem Prozessraum (21, 21') aufweisen, wobei das Gaszufuhrelement und/oder Gasabfuhrelement (100a, 100b) beispielsweise als ein in das erste Beabstandungselement (70a bis 70e) und/oder das zweite Beabstandungselement (80a, 80b) integrierter Gasverteiler-Kamm mit mindestens einem Anschlusselement (101) zum Anschließen einer Gaszuführleitung und/oder Gasabführleitung ausgebildet ist.

10. Mehrschichtkörperanordnung (28a bis 28e) nach einem der Ansprüche 5 bis 9, bei welcher das erste Beabstandungselement (70a bis 70e) und/oder das zweite Beabstandungselement (80a, 80b) jeweils mindestens ein Querverbindungselement (74, 75, 76, 81) zum Verbinden von, in der Erstreckungsebene der Mehrschichtkörper (40, 50) sich gegenüberliegenden Bereichen des jeweiligen Rahmenelements (71) oder von sich im Gebrauch gegenüberliegenden Rahmenleistenelementen (72, 73) aufweisen, so dass der oder die Mehrschichtkörper (40, 50) zur Vermeidung einer Durchbiegung zusätzlich abstützbar ist oder sind.

11. Mehrschichtkörperanordnung (28a bis 28e) nach Anspruch 10, bei welcher das Querverbindungselement (74, 75, 76, 81) mindestens ein Abstützelement (90) aufweist, insbesondere ein Punktstützenelement, beispielsweise ein Kugelelement, so dass die Mehrschichtkörper (40, 50) dem Querverbindungselement (74, 75, 76, 81) über das Abstützelement (90) auf- oder anliegen, wobei das Abstützelement (90) derart ausgebildet ist, dass es dieselbe Höhe wie das jeweilige mindestens eine Rahmenelement oder Rahmenleistenelement (71, 72, 73) aufweist.

12. Mehrschichtkörperanordnung (28a bis 28e) nach einem der Ansprüche 7 bis 11, bei welcher das mindestens eine Rahmenelement oder Rahmenleistenelement (71, 72, 73) mindestens zwei Abstützelemente (90) derart aufweist, dass die Mehrschichtkörper (40, 50) den Abstützelementen (90) auf- oder anliegen, derart, dass an den Querseiten (68, 69) und/oder Längsseiten (66, 67) der Mehrschichtkörperanordnung (40, 50) jeweils mindestens ein Öffnungsbereich (60, 61, 62, 63, 64, 65) zum Zuführen und/oder Abführen des Prozessgases in den und/oder aus dem Prozessraum (21') ausgebildet ist.

13. Anlage (10) zum Prozessieren, insbesondere zum Selenisieren, von mindestens zwei Mehrschichtkörpern (40, 50) mit jeweils mindestens einer zu prozessierenden Oberfläche (44, 54), welche mindestens eine Prozesskammer (11) mit einem Kammerraum (12) und einer darin angeordneten Mehrschichtkörperanordnung nach einem der Ansprüche 1 bis 12 umfasst.

14. Verfahren zum Prozessieren von mindestens zwei Mehrschichtkörpern (40, 50) mit jeweils mindestens einer zu prozessierenden Oberfläche (44, 54), bei welchem die beiden Mehrschichtkörper (40, 50) derart angeordnet werden, dass sich die jeweils zu prozessierenden Oberflächen (44, 54) gegenüberliegen **dadurch gekennzeichnet, dass** sie so einen zwischen den Oberflächen (44, 54) angeordneten, quasi-geschlosenen Prozessraum (21') ausbilden, in dem die Prozessierung erfolgt, wobei quasi-geschlossen einen Prozessraum beschreibt, der am Rand offen ist und bei dem für den Zeitraum der Prozessierung der Mehrschichtkörper praktisch kein Gasaustausch zwischen dem Prozessraum und seiner Umgebung stattfindet, so dass keine nennenswerte Veränderung der Prozessbedingungen im Prozessraum stattfindet.

15. Verwendung einer Mehrschichtkörperanordnung nach einem der Ansprüche 1 bis 12, sowie eines Verfahrens nach Anspruch 14 zur Herstellung einer Dünnschichtsolarzelle bzw. eines Dünnschichtsolarmoduls, insbesondere einer CIS(CIGSSe)-Dünnschichtsolarzelle bzw. eines CIS(CIGSSe)-Dünnschichtsolarmoduls, wobei insbesondere jeder Mehrschichtkörper in Form einer Glasscheibe ausgebildet und mit mindestens den Elementen Cu, In oder Cu, In, Ga oder Cu, In, Ga, Selen zur Selenisierung und/oder Sulfurisierung eines Chalkopyritdünnschichthalbleiters beschichtet ist.

## Claims

1. Multilayer body arrangement (28a through 28e), comprising
- at least two multilayer bodies (40, 50) each having at least one surface to be processed (44, 54),
- at least one device (30a through 30g) for positioning the multilayer bodies (40, 50), wherein the device (30a through 30g) is configured such that the respective surfaces to be processed (44, 54) are opposite each other, **characterized in that** they thus form a quasi-closed processing space (21') disposed between the surfaces (44, 54), in which the processing occurs, wherein quasi-closed describes a processing space that is open on the edge and in which during the period of the processing of the multilayer bodies virtually no gas exchange occurs between the processing space and its surroundings, such that no significant change of the process conditions occurs in the processing space.

2. Multilayer body arrangement (28a through 28e) according to claim 1, which is disposed
- in a processing chamber, or
- in a processing tunnel (11) of a processing system (10) with a chamber space (12), and/or
- in a device (20) for forming a reduced chamber space, for example, in a process box (20) or inside a process hood, that is formed, in particular, for stationary retention in a processing system (10), and/or
- on a carrying element for transporting by means of a transport device into a processing system (10) and out from it.

3. Multilayer body arrangement (28a through 28e) according to claim 2, wherein the device (30a through 30g) is formed so as to dispose the two multilayer bodies (40, 50) such that they form, at least partially, the device (20) for forming a reduced chamber space.

4. Multilayer body arrangement (28a through 28e) according to one of claims 1 through 3, wherein the device (30a through 30g) is configured such that the multilayer bodies (40, 50) are disposed sandwich-like on top of each other while in use and thus form a bottom multilayer body (40) and a top multilayer body (50).

5. Multilayer body arrangement (28a through 28e) according to claim 4, wherein the device (30a through 30g) has at least a first spacing element (70a, 70b, 70c, 70d, 70e), that is configured to accommodate the top multilayer body (50) and/or the bottom multilayer body (40), with the spacing element (70a through 70e) disposed at least partially between the two multilayer bodies (40, 50) such that they are disposed with space between them.

6. Multilayer body arrangement (28a through 28e) according to claim 5, wherein the device (30a through 30g) has at least a second spacing element (80a, 80b), that is configured to accommodate the top multilayer body (50) and/or the bottom multilayer body (40) and is configured to accommodate the first spacing element (70a through 70e) such that the second spacing element (80a, 80b), the bottom multilayer body (40), the first spacing element (70a through 70e), and the top multilayer body (50) are disposed sandwich-like.

7. Multilayer body arrangement (28a through 28e) according to one of claims 5 or 6, wherein the first spacing element (70a through 70e) and/or the second spacing element (80a, 80b) has, in each case, at least one frame element (71) and/or a frame strip element (72, 73), such that the multilayer bodies (40, 50), in particular, on their edge regions (41, 51) at least partially abut or rest on the frame element and/or the frame strip element (71, 72, 73).

8. Multilayer body arrangement (28a through 28e) according to one of claims 5 through 7, wherein the first spacing element and/or the second spacing element (80a, 80b) have/has two frame strip elements (72, 73), that are opposite each other while in use in a plane of extension of the multilayer bodies (40, 50), such that the multilayer bodies (40, 50), in particular, on their edge regions (41, 51), in particular, on their longitudinal sides, at least partially abut or rest on the frame strip elements (72, 73) such that on the multilayer body arrangement (28a through 28e), in particular, in each case, on the transverse sides (68, 69), at least one opening area (60, 61) is formed to feed and/or to evacuate a process gas into and/or out of the processing space (21').

9. Multilayer body arrangement (28a through 28e) according to one of claims 5 through 8, wherein the first spacing element (70a through 70e) and/or the second spacing element (80a, 80b) has a gas feed element and/or gas evacuation element (100a, 100b) to feed and/or to evacuate the process gas into and/or out of the processing space (21, 21'), wherein the gas feed element and/or gas evacuation element (100a, 100b) is configured, for example, as a gas diffuser comb integrated into the first spacing element (70a through 70e) and/or the second spacing element (80a, 80b) with at least one connector element (101) to connect a gas feed line and/or a gas evacuation line.

10. Multilayer body arrangement (28a through 28e) according to one of claims 5 through 9, wherein the first spacing element (70a through 70e) and/or the second spacing element (80a, 80b) each has at least one cross-connection element (74, 75, 76, 81) for connection of regions of the respective frame element (71) opposite each other in the plane of extension of the multilayer bodies (40, 50) or of frame strip elements (72, 73) opposite each other while in use, such that the multilayer body (bodies) (40, 50) can also be supported to prevent bending.

11. Multilayer body arrangement (28a through 28e) according to claim 10, wherein the cross-connection element (74, 75, 76, 81) has at least one support element (90), in particular, a point support element, for example, a spherical element, such that the multilayer bodies (40, 50) rest on or abut the cross-connection element (74, 75, 76, 81) via the support element (90), wherein the support element (90) is formed such that it has the same height as the respective at least one frame element or frame strip element (71, 72, 73).

12. Multilayer body arrangement (28a through 28e) according to one of claims 7 through 11, wherein the at least one frame element or frame strip element (71, 72, 73) has at least two support elements (90) such that the multilayer bodies (40, 50) rest on or abut the support elements (90), such that on the transverse sides (68, 69) and/or longitudinal sides (66, 67) of the multilayer body arrangement (40, 50), at least one opening region (60, 61, 62, 63, 64, 65) is formed for the feeding and/or evacuation of the process gas into and/or out of the processing space (21').

13. System (10) for processing, in particular for selenizing, at least two multilayer bodies (40, 50) each having at least one surface to be processed (44, 54), that comprises at least one process chamber (11) with a chamber space (12) and a multilayer body arrangement disposed therein according to one of claims 1 through 12.

14. Method for processing at least two multilayer bodies (40, 50) each having at least one surface to be processed (44, 54), wherein the two multilayer bodies (40, 50) are disposed such that the respective surfaces to be processed (44, 54) are opposite each other **characterized in that** they thus form a quasi-closed processing space (21') disposed between the surfaces (44, 54), in which the processing occurs, wherein quasi-closed describes a processing space that is open on the edge and in which during the period of the processing of the multilayer bodies virtually no gas exchange occurs between the processing space and its surroundings, such that no significant change of the process conditions occurs in the processing space.

15. Use of a multilayer body arrangement according to one of claims 1 through 12, as well as a method according to claim 14 for production of a thin-film solar cell or of a thin-film solar module, in particular a CIS(CIGSSe)-thin-film solar cell or a CIS(CIGSSe)-thin-film solar module, wherein, in particular, each multilayer body is implemented in the form of a glass pane and is coated with at least the elements Cu, In or Cu, In, Ga or Cu, In, Ga, selenium for the selenization and/or sulfurization of a chalcopyrite thin-film semiconductor.

## Revendications

1. Arrangement de corps multicouches (28a à 28e), comprenant
- au moins deux corps multicouches (40, 50) dont chacun présente au moins une surface à traiter (44, 54),
- au moins un dispositif (30a à 30g) pour le positionnement des corps multicouches (40, 50), où le dispositif (30a à 30g) est configuré de telle manière que les surfaces à traiter (44, 54) se trouvent l'une en face de l'autre, **caractérisé en ce qu'**ils forment ainsi un espace de traitement quasiment fermé (21') dans lequel le traitement a lieu disposé entre les surfaces (44, 54), où le terme quasiment fermé décrit un espace de traitement qui est ouvert au bord et par lequel, pendant le temps du traitement des corps multicouches pratiquement aucun échange de gaz n'a lieu entre l'espace de traitement et son environnement, de sorte qu'aucun changement significatif des conditions de traitement dans l'espace de traitement n'a lieu.

2. Arrangement de corps multicouches (28a à 28e) selon la revendication 1, qui est formé
- dans un espace de traitement, ou dans un tunnel de traitement (11) d'une installation de traitement (10) avec un espace de chambre (12), et/ou
- dans un dispositif (20) pour former un espace de chambre réduit, par exemple dans une boîte de traitement (20) ou à l'intérieur d'une hotte de traitement, qui est formé en particulier pour la rétention stationnaire dans une installation de traitement (10), et/ou est disposé
- sur ou en contact avec un élément de support pour le transport au moyen d'un dispositif de transport dans une installation de traitement (10) et enlevé de celui-ci.

3. Arrangement de corps multicouches (28a à 28e) selon la revendication 2, où le dispositif (30a à 30g) est conçu de telle manière pour disposer les deux corps multicouches (40, 50) de telle manière que ceux-ci forment au moins partiellement le dispositif (20) pour former un espace de chambre réduit.

4. Arrangement de corps multicouches (28a à 28e) selon l'une des revendications 1 à 3, où le dispositif (30a à 30g) est conçu de telle manière que les corps multicouches (40, 50) en cours d'utilisation sont disposés superposés en forme de sandwich et forment ainsi un corps multicouches inférieur (40) et un corps multicouches supérieure (450).

5. Arrangement de corps multicouches (28a à 28e) selon la revendication 4, où le dispositif (30a à 30g) présente au moins un premier élément d'espacement (70a, 70b, 70c, 70d, 70e) qui est conçu pour accueillir le corps multicouches supérieur (50) et/ou le corps multicouches inférieur (40), où l'élément d'espacement (70a à 70e) est disposé au moins partiellement entre les deux corps multicouches (40, 50), de telle manière que ceux-ci sont disposés espacés l'un par rapport l'autre.

6. Arrangement de corps multicouches (28a à 28e) selon la revendication 5, où le dispositif (30a à 30g) présente au moins un deuxième élément d'espacement (80a, 80b) qui est conçu pour accueillir le corps multicouches supérieure (50), et/ou le corps multicouches inférieur (40) et pour accueillir le premier élément d'espacement (70a à 70e), de telle manière que le deuxième élément d'espacement (80a, 80b), le corps multicouches inférieur (40), le premier élément d'espacement (70a à 70e) et le corps multicouches supérieur (50) sont disposés en forme de sandwich.

7. Arrangement de corps multicouches (28a à 28e) selon l'une des revendications 5 ou 6, où le premier élément d'espacement (70a à 70e) et/ou le deuxième élément d'espacement (80a, 80b) présentent chacun au moins un élément de cadre (71) et/ou un élément de moulure de cadre (72, 73) de telle manière que les corps multicouches (40, 50) en particulier sur leur zone de bordure (41, 51) reposent au moins partiellement sur ou contre l'élément de cadre et/ou l'élément de moulure de cadre (71, 72, 73).

8. Arrangement de corps multicouches (28a à 28e) selon l'une des revendications 5 à 7, où le premier élément d'espacement et/ou le second (80a, 80b) présentent deux éléments de moulure de cadre (72, 73), qui se trouvent l'un en face de l'autre en cours d'utilisation dans un plan d'extension des corps multicouches (40, 50), en particulier sur leur zone de bordure (41, 51), en particulier sur leur côté longitudinal, reposent au moins partiellement sur ou contre les éléments de moulure de cadre (72, 73), de telle manière que sur l'arrangement de corps multicouches (28a à 28e), en particulier sur le côté transversal respectif (68, 69), au moins une zone d'ouverture (60, 61) pour l'alimentation et/ou l'évacuation d'un gaz de traitement dans et/ou depuis l'espace de traitement (21').

9. Arrangement de corps multicouches (28a à 28e) selon l'une des revendications 5 à 8, où le premier élément d'espacement (70a à 70e) et/ou le deuxième élément d'espacement (80a, 80b) est un élément d'alimentation en gaz et/ou un élément d'évacuation de gaz (100a, 100b) pour l'alimentation et/ou l'évacuation du gaz de traitement dans et/ou depuis l'espace de traitement (21, 21'), où l'élément d'alimentation en gaz et/ou l'élément d'évacuation de gaz (100a, 100b) est formé par exemple comme peigne d'un distributeur de gaz intégré dans le premier élément d'espacement (70a à 70e) et/ou le deuxième élément d'espacement (80a, 80b) avec au moins un l'élément de connexion (101) pour le raccordement d'un conduit d'alimentation en gaz et/ou d'un conduit d'évacuation de gaz.

10. Arrangement de corps multicouches (28a à 28e) selon l'une des revendications 5 à 9, où le premier élément d'espacement (70a à 70e) et/ou le deuxième élément de d'espacement (80a, 80b) présentent au moins un élément de raccordement transversal (74, 75, 76, 81) pour le raccordement des zones opposées dans le plan d'extension des corps multicouches (40, 50) de l'éléments de cadre (71) respectif ou d'éléments de moulure de cadre opposés (71) (72, 73) en cours d'utilisation, de telle manière que le ou les corps multicouches (40, 50) peuvent être en outre soutenus pour éviter la flexion.

11. Arrangement de corps multicouches (28a à 28e) selon la revendication 10, où l'élément de raccordement transversal (74, 75, 76, 81) présente au moins un élément de soutien (90), en particulier, un élément de soutien d'un point, par exemple un élément sphérique, et ainsi les corps multicouches (40, 50) reposent sur ou contre l'élément de raccordement transversal (74, 75, 76, 81) par l'intermédiaire de l'élément de soutien (90), où l'élément de soutien (90) est conçu pour avoir la même hauteur respective que ledit au moins un élément de cadre ou élément de moulure de cadre (71, 72, 73).

12. Arrangement de corps multicouches (28a à 28e) selon l'une des revendications 7 à 11, où ledit au moins un élément de cadre ou élément de moulure de cadre (71, 72, 73) dispose d'au moins deux éléments de soutien (90) de telle manière que les corps multicouches (40, 50) reposent sur ou contre les éléments de soutien (90), de telle manière que sur les côtés transversaux (68, 69) et/ou longitudinaux (66, 67) de l'arrangement de corps multicouches (40, 50) au moins une zone d'ouverture (60, 61, 62, 63, 64, 65) est formée pour l'alimentation et/ou l'évacuation du gaz de traitement dans et/ou depuis l'espace traitement (21').

13. Installation (10) pour le traitement, en particulier pour la sélénisation d'au moins deux corps multicouches (40, 50), dont chacun présente au moins une surface à traiter (44, 54), qui comprend au moins un espace de traitement (11) avec un espace de chambre (12) dans lequel est disposé un corps multicouche, selon l'une ou l'autre des revendications 1 à 12.

14. Procédé de traitement d'au moins deux corps multicouches (40,
50) dont chacun présente au moins une surface à traiter (44, 54), où les deux corps multicouches (40, 50) sont disposés de telle sorte que les surfaces à traiter (44, 54) se trouvent l'une en face de l'autre, **caractérisé en ce qu'**ils forment ainsi un espace de traitement quasiment fermé (21') dans lequel le traitement a lieu disposé entre les surfaces (44, 54), où le terme « quasiment fermé » décrit un espace de traitement qui est ouvert au bord et par lequel, pendant le temps du traitement des corps multicouches pratiquement aucun échange de gaz n'a lieu entre l'espace de traitement et son environnement, de sorte qu'aucun changement significatif des conditions de traitement dans l'espace de traitement n'a lieu.

15. Utilisation d'un arrangement de corps multicouches selon l'une des revendications 1 à 12, ainsi qu'un procédé selon la revendication 14 pour la production d'une cellule solaire à couches minces ou d'un module solaire à couches minces, en particulier d'une cellule solaire à couches minces CIS (CIGSSe)- ou d'un module solaire à couches minces CIS (CIGSSe), où en particulier chaque corps multicouches est conçu sous la forme d'une vitre et est revêtu d'au moins les éléments Cu, In ou Cu, In, Ga ou Cu, In, Ga, sélénium pour la sélénisation et/ ou la sulfurisation d'un semi-conducteur à couches minces chalcopyrite.
